# EUROPÄISCHE PATENTANMELDUNG

(11) **EP 4 794 199 A1**
(43) Veröffentlichungstag der Anmeldung: **19.08.2026**
(21) Anmeldenummer: 25157737.5
(22) Anmeldetag: 13.02.2025
(51) Int. Cl.: H03K 17/965

(54) **GEKAPSELTES SENSORBASIERTES ELEKTROINSTALLATIONSGERÄT**

(71) Anmelder: GIRA Giersiepen GmbH & Co. KG, 42477 Radevormwald (DE); Hochschule Bochum, Bochum 44801 (DE)
(72) Erfinder: LOHMANN, Achim, 58579 Schalksmühle (DE); SEIFERT, Roland, 59071 Hamm (DE); GERHARDT, Dietmar, 44801 Bochum (DE); HACIA, Silvia, 44801 Bochum (DE)
(74) Vertreter: Dr. Solf & Zapf Patent- und Rechtsanwalts PartG mbB

(57) **Zusammenfassung**

Die vorliegende Erfindung betrifft ein Elektroinstallationsgerät (1) zur Steuerung eines elektrischen Verbrauchers, aufweisend ein Leistungsteil (2) und ein Bedienteil (4). Das Leistungsteil (2) weist ein Gehäuse (6) mit Befestigungsmitteln zur Montage in einer Einbauöffnung und in einem Aufnahmeraum (10) des Gehäuses (6) eine Schaltelektronik (12) zur Überwachung und Auswertung von Schaltzuständen des Bedienteils (4) und zur Steuerung des Verbrauchers auf, und das Bedienteil (4) ist zur lösbaren Befestigung auf einer Wandung einer Gehäuseoberseite (14) des Leistungsteils (2) ausgebildet, wobei das Bedienteil (4) mindestens ein Betätigungsmittel (16) zur Auswahl der Schaltzustände aufweist. Das Leistungsteil (2) weist zumindest einen mit der Schaltelektronik (12) elektrisch verbundenen und mit dem Bedienteil (4) zusammenwirkenden elektronischen, elektromagnetischen, induktiven, kapazitiven, optischen, elektromechanischen oder piezoelektrischen Sensor (22, 24, 26, 28, 30, 32) auf.

## Beschreibung

Die Erfindung betrifft ein Elektroinstallationsgerät zur Steuerung eines elektrischen Verbrauchers. Das Elektroinstallationsgerät weist ein Leistungsteil und mindestens ein Bedienteil auf. Das Leistungsteil weist ein Gehäuse mit Befestigungsmitteln zur Montage in einer Einbauöffnung auf. In einem Aufnahmeraum des Gehäuses ist eine Schaltelektronik des Leistungsteils zur Steuerung des Verbrauchers und zur Überwachung und Auswertung von Schaltzuständen des Bedienteils angeordnet. Das Bedienteil ist zur lösbaren Befestigung auf einer Wandung einer Gehäuseoberseite des Leistungsteils ausgebildet. Darüber hinaus weist das Bedienteil mindestens ein Betätigungsmittel zur Auswahl der Schaltzustände auf.

Das Leistungsteil weist insbesondere elektrische Kontakte zur Kontaktierung einer Spannungsquelle und vorzugsweise mindestens ein Haltemittel zur lösbaren Befestigung des Bedienteils auf.

Die Einbauöffnung kann im erfindungsgemäßen Sinn sowohl für eine Unterputz-Montage in einer Wand als auch für eine Aufputz-Montage in einer Gerätedose, die auf der Wand montierbar ist, ausgebildet sein.

Elektroinstallationsgeräte zur Steuerung eines Verbrauchers sind insbesondere in der Hausinstallationstechnik bekannt und finden regelmäßig Anwendung als Schalter, Taster oder Dimmer für Leuchtmittel, z. B. Raumlampen, oder Fensterrollladen. Dabei sind die bekannten Elektroinstallationsgeräte entweder als ein kompaktes Gerät mit fest integriertem Bedienelement oder mehrteilig mit lösbar verbindbaren Teilen aufgebaut. Die mehrteiligen Elektroinstallationsgeräte weisen in der Regel einen als Leistungsteil ausgebildeten Einsatz und einen als Bedienteil ausgebildeten Aufsatz auf.

Der Einsatz umfasst in der Regel ein funktionsabhängiges (Schalten, Tasten, Dimmen, etc.) Schaltwerk, welches elektromechanisch oder elektronisch ausgebildet sein kann und die Strom- bzw. Spannungszufuhr des Verbrauchers direkt steuert. Zudem kann der Einsatz auch eine Datenkommunikationsschnittstelle aufweisen, um den Verbraucher indirekt mittels eines weiteren Aktuators über ein Hauskommunikationsnetz zu steuern. Vorteilhafterweise stellt der Einsatz auch, wenn benötigt, eine Betriebsspannung für das Elektroinstallationsgerät zur Verfügung, z.B. für eine Schaltelektronik, eine Beleuchtung des Aufsatzes oder für Kommunikationsschnittstellen.

Als Schnittstelle zwischen Einsatz und Aufsatz dient eine direkte mechanische und/oder elektrische Verbindung, über die die Steuersignale und/oder eine Betriebsspannung für den Aufsatz übertragen werden.

Es ist aus dem Stand der Technik bekannt, Einbaudosen oder spezielle Einbauöffnungen bereitzustellen, welche auf- und/oder unterputz montierbar sind und in die ein Elektroinstallationsgerät eingesetzt werden kann. Die Einbauöffnungen weisen dabei regelmäßig eine genormte Größe auf, so dass verschiedenartige Elektroinstallationsgeräte in die Einbauöffnung einsetzbar sind, wobei die Tiefe der Elektroinstallationsgeräte in eine Montagerichtung weisend variieren kann.

Aufgrund unterschiedlicher landesspezifischer Stromnetze, z. B. 110 V- oder 230 V-Spannungsnetze, sowie unterschiedlicher Kommunikationsnetze der Haustechnik selbst, beispielsweise die Verwendung von EIB/KNX-, Ethernet-, Powerline-, 868 MHz Funk-, Bluetooth-, WLAN- und anderer Kommunikationsstandards, sind bekannte Elektroinstallationsgeräte auf bestimmte Regionen und/oder Kommunikationsnetze beschränkt. Alle diese Netze werden im Sinne der Erfindung unter dem Begriff Hausnetz zusammengefasst.

Durch die im Unterputzbereich normativen Bedingungen werden die Elektroinstallationsgeräte über einen Tragring durch Verschraubung oder über Klemmkrallen mit einer Unterputzdose verbunden. Durch dieses Montagekonzept bedingt sind die Elektroinstallationsgeräte überwiegend als Einsatz und Aufsatz zweigeteilt ausgeführt. In einem ersten Montageschritt wird der Einsatz in die Unterputzdose eingebracht und entweder über eine Verschraubung des Tragrings oder durch Klemmkrallen befestigt. Danach werden in einem zweiten Schritt der Rahmen und der Aufsatz auf den Einsatz gesteckt. Dieses Montagekonzept hat zur Folge, dass eine mechanische Schnittstelle ausgeführt wird, um eine feste Verbindung zwischen Aufsatz (Bedienteil) und Einsatz (Leistungsteil) zu gewährleisten. Zusätzlich ist eine elektrische Schnittstelle notwendig, um die Schaltbefehle des Nutzers als Schaltsignale über die Schaltkontakte im Bedienteil an die Elektronik im Leistungsteil zu übertragen. Überwiegend werden im Bedienteil dafür mechanische Kontakte eingesetzt. Üblich ist die Verwendung von einzelnen Mikroschaltern oder Schaltmatten oder auch Metallkontakten.

Die Steuerzustände (z.B. Kontakt "offen" oder "geschlossen") des Aufsatzes werden durch die Elektronik im Einsatz überwacht und ausgewertet. Die dabei notwendige elektrische Verbindung zwischen Aufsatz und Einsatz wird in vielen Fällen durch Stecker-Buchsen-Verbindungen oder Flachband-Leiterbahnen realisiert. Gleiches gilt sinngemäß für Schalter mit fest integriertem Bedienelement.

Um die Funktion oder die Bedienung in einem Gebäude funktionell oder strukturell anzupassen, werden die aus dem Stand der Technik bekannten Elektroinstallationsgeräte regelmäßig vollständig ausgetauscht. Auch ist es bekannt, z. B. eine Schaltwippe des Bedienteils bzw. einen Einbaurahmen bezüglich des äußeren Erscheinungsbildes zu tauschen, um das Elektroinstallationsgerät an ein neues Design anzupassen.

Bei den bekannten Elektroinstallationsgeräten ist die Anpassbarkeit daher in der Regel über einen Austausch des vollständigen Gerätes oder über das Austauschen von Designelementen, die keine für die Funktion wesentliche Änderung bedeuten, begrenzt, so dass die funktionelle Flexibilität stark eingeschränkt ist. Infolgedessen müssen sich der Hersteller und der Endbenutzer auf eine bestimmte Art der Bedienung und der Kommunikation bzw. der Vernetzung festlegen. Bei einem als Dimmer ausgebildeten Elektroinstallationsgerät hat der Benutzer zum Beispiel die Wahl zwischen einer mechanischen Taste, einem Drehknopf oder einem so genannten "Touch-Dimmer" mit berührungssensitiver Fläche. Ein nachträgliches Ändern, beispielsweise von einer mechanischen Taste auf einen Drehknopf, ist meist nur durch einen Austausch des gesamten Elektroinstallationsgerätes möglich, da die Schnittstellen zwischen Einsatz und Aufsatz in der Regel funktionsspezifisch sind. Eine ähnliche Problematik tritt bei bekannten Elektroinstallationsgeräten auf, wenn es zu einem Austausch des Hausnetzes kommt, z. B. umzugsbedingt, und die Elektroinstallationsgeräte weiterverwendet werden sollen. Dies muss in der Regel durch einen vollständigen Austausch aller miteinander kommunizierenden Elektroinstallationsgeräte verwirklicht werden, was insbesondere hohe Kosten verursacht.

Weiterhin kann es z. B. im Zuge einer Raumneugestaltung zu einer neuen Designausrichtung kommen, so dass die ursprünglichen Elektroinstallationsgeräte nicht mehr in das gewünschte Funktionskonzept passen oder z. B. bestimmte Funktionen, z. B. beleuchtete Schalter oder andere Sicherheitsaspekte, auch unter Betrachtung von barrierefreiem Wohnen, nicht erfüllen. In diesem Zusammenhang sind insbesondere auch Umbauten für ein seniorengerechtes Wohnen zu nennen, wodurch oft die Bedienfunktionen angepasst werden müssen. Auch dies bedingt in der Regel einen vollständigen Austausch der Elektroinstallationsgeräte.

Zudem sind die bekannten elektrischen und/oder mechanischen Schnittstellen zwischen dem Einsatz und dem Aufsatz anfällig für Staub und Verschmutzungen, da die Einsätze vor und die Aufsätze nach dem Anstreichen oder Tapezieren der Räume montiert werden. Insbesondere Verschmutzungen durch Farbe oder Tapetenkleber können die Funktionstüchtigkeit und Langlebigkeit der Elektroinstallationsgeräte negativ beeinflussen. In diesem Zusammenhang ergibt sich auch die Problematik eines Toleranzausgleichs, um eine möglichst identische Funktionsweise der Schnittstelle zwischen Einsatz und Aufsatz und/oder ein identisches Erscheinungsbild, insbesondere der Spaltmaße zwischen Bedienteil und Rahmen, zu ermöglichen.

Der Erfindung liegt die Aufgabe zugrunde, Elektroinstallationsgeräte zur Verfügung zu stellen, welche sich in der Funktion, Vernetzung und/oder der Bedienung und/oder dem Design leichter anpassen bzw. ändern lassen und gleichzeitig möglichst resistent gegenüber äußeren Einflüssen sind.

Die Aufgabe wird erfindungsgemäß durch ein Elektroinstallationsgerät mit den Merkmalen des Anspruchs 1 dadurch gelöst, dass das Leistungsteil zumindest einen mit der Schaltelektronik elektrisch verbundenen und mit dem Bedienteil zusammenwirkenden elektronischen, elektromagnetischen, induktiven, kapazitiven, optischen, elektromechanischen oder piezoelektrischen Sensor aufweist.

Die hier ausgeführte Idee beschreibt eine teilbare Aufteilung des Elektroinstallationsgerätes in ein als Einsatz ausgebildetes Leistungsteil und ein als Aufsatz ausgebildetes Bedienteil. Das Leistungsteil ist vorzugsweise derart ausgebildet, dass es mit einer Vielzahl unterschiedlicher Bedienteilen (z.B. Schalten, Tasten, Dimmen) kompatibel ist und/oder eine Vielzahl von unterschiedlichen Schaltfunktionen einem Bedienteil zuweisen kann. Schaltfunktionen können sich im Rahmen der erfinderischen Idee auf das Ansteuern unterschiedlicher elektrischer Verbraucher und/oder auf eine Art der Ansteuerung der elektrischen Verbraucher, beispielsweise Dimmen und/oder Schalten, beziehen.

Vorzugsweise ist die Schnittstelle zwischen Leistungsteil und Bedienteil unabhängig von der Steuerfunktion des Bedienteils und unabhängig von der Funktion des Leistungsteils ausgebildet. Insbesondere ermöglicht die Schnittstelle zwischen Leistungsteil und Bedienteil eine, vorzugsweise kontaktlose, Überwachung und Auswertung der Schaltzustände im Bedienteil.

Der Vorteil des erfindungsgemäßen Konzeptes ist insbesondere, dass eine Durchdringung der Gehäuse des Leistungsteils (Einsatz) oder des Aufsatzes (Bedienteil) durch eine elektrische Verbindung entfallen kann. Zumindest die Gehäuseoberseite des Leistungsteils kann dadurch vorteilhafterweise vollflächig geschlossen, insbesondere ohne eine Öffnung für eine elektrische Leitung oder eine mechanische Verbindung zwischen Bedienteil und Leistungsteil, ausgebildet werden. Während herkömmliche Geräte aufgrund mechanischer Schnittstellen anfällig für Verschmutzungen und Abnutzung sind, eliminiert die vorliegende Erfindung diese Schwachstelle durch den Einsatz kontaktloser Sensortechnologie.

Dadurch ergeben sich Vorteile einer einfacheren und kostenoptimierten Konstruktion des Elektroinstallationsgerätes. Schaltkontakte im Bedienteil und damit die Nachteile dieser Kontakte (z. B. Erhöhung des Kontaktwiderstandes durch Verschmutzungen; langfristige Veränderung der Federkonstante und damit die einhergehende Veränderung des Schaltprofils) können entfallen. Ein Risiko durch spannungsführende Verbindungen im Bedienteil entfällt ebenfalls.

Im Gegensatz zu herkömmlichen Elektroinstallationsgeräten bietet die vorliegende Erfindung durch eine modulare Bauweise und die kontaktlose Schnittstelle zum Bediengerät eine deutlich erhöhte Flexibilität bei der Anpassung an verschiedene Kommunikationsstandards und Nutzeranforderungen.

Um den zumindest einen Sensor insbesondere vor Fremdeinwirkung, Feuchtigkeit und Schmutz zu schützen, ist zumindest der eine Sensor, gemäß einer vorteilhaften Ausführung, im Inneren des Gehäuses, insbesondere im Aufnahmeraum, des Leistungsteils an einer Innenseite der Wandung der Gehäuseoberseite angeordnet. Als Alternative dazu kann zum Schutz zumindest des einen Sensors auch vorgesehen sein, dass zumindest der eine Sensor des Leistungsteils zumindest teilweise in die Wandung der Gehäuseoberseite integriert ist.

Vorteilhaft kann der jeweilige Sensor in die Wandung der Gehäuseoberseite zumindest teilweise integriert werden, indem zumindest die Wandung der Gehäuseoberseite als ein aus einer Kunststoffmasse spritzgegossenes Kunststoffbauteil ausgebildet ist. Zweckmäßig kann im Herstellungsprozess zumindest der eine Sensor von der Kunststoffmasse umspritzt werden. Vorteilhaft kann vorgesehen sein, dass elektrische Leiterbahnen des zumindest einen Sensors in einem speziellen Verfahren unmittelbar auf/in die Wandung der Gehäuseoberseite eingebracht werden, so dass die jeweilige Wandung der Gehäuseoberseite als ein spritzgegossener Schaltungsträger ausgebildet ist.

Eine besondere Ausführungsvariante der Erfindung sieht vor, dass das Betätigungsmittel des Bedienteils zur Auswahl der Schaltzustände mechanisch zwischen zumindest zwei Stellungen gelagert ist. Zumindest der eine Sensor des Leistungsteils ist in dieser Ausführungsform zur Erfassung der mechanischen Stellung des Betätigungsmittels des Bedienteils ausgebildet. Vorteilhaft ist die mechanische Lagerung bzw. das Betätigungsmittel derart ausgestaltet, dass der Benutzer unmittelbar die Verwendung bzw. Bedienung des Elektroinstallationsgerätes erkennen kann, insbesondere indem das Betätigungsmittel als eine mechanisch gelagerte Wippe oder Taste ausgebildet ist.

Vorteilhaft kann zumindest der eine Sensor die mechanische Stellung des Betätigungsmittels dadurch detektieren, dass das Bedienteil ein relativ zu dem Sensor des Leistungsteils in Abhängigkeit von der mechanischen Stellung des Betätigungsmittels des Bedienteils unterschiedlich positionierbares Sensorelement aufweist. Das Sensorelement des Bedienteils ist zweckmäßig mit dem Betätigungsmittel des Bedienteils direkt oder indirekt mechanisch verbunden. Zumindest der eine Sensor des Leitungsteils und das Sensorelement des Bedienteils sind vorteilhaft derart korrespondierend zueinander ausgebildet, dass eine Bewegung des Sensorelements von dem Sensor des Leistungsteils erfassbar ist.

Es hat sich als vorteilhaft herausgestellt, dass das Sensorelement optisch wirksam, metallisch, dielektrisch, magnetisch und/oder als Kontaktelement zur Auflage auf der Gehäuseoberfläche des Leistungsteils im Bereich des zumindest einen Sensors des Leistungsteils ausgebildet ist. Vorzugsweise ist zumindest der eine Sensor des Leitungsteils korrespondierend zu der Erfassung der jeweiligen Variante des Sensorelements des Bedienteils ausgebildet.

Gemäß einer bevorzugten Variante ist das Sensorelement durch das Betätigungsmittel außen entlang einer Wandung der Gehäuseoberseite des Leistungsteils in horizontaler Richtung verschiebbar ausgebildet. Vorteilhaft lässt sich dadurch das Elektroinstallationsgerät flach ausbilden, so dass die jeweilige Tiefe der Einbauöffnung zur Anordnung des Leistungsteils geringgehalten werden kann und/oder das Elektroinstallationsgerät nur einen geringen Überstand zu einer die Einbauöffnung umfangsgemäß umgebenden Wandung aufweist.

Alternativ oder ergänzend kann vorgesehen sein, dass das Sensorelement durch das Betätigungsmittel außen in vertikaler Richtung zu der Gehäuseoberseite des Leistungsteils verschiebbar ausgebildet ist. Insbesondere wenn das Betätigungsmittel als eine mechanisch verschiebbare oder um eine Lagerachse verschwenkbar gelagerte Taste ausgebildet ist, eignet sich diese Variante besonders vorteilhaft aufgrund ihrer aufwandsarmen Umsetzung.

Zweckmäßig ist zumindest der eine Sensor des Leistungsteils als eine planare elektromagnetische Spule ausgebildet. Die Spule ist insbesondere derart ausgebildet, dass die Schaltelektronik mittels der Spule sowohl eine horizontale Verschiebung des Sensorelements als auch eine vertikale Verschiebung des Sensorelements relativ zu der Gehäuseoberseite detektieren kann. Vorzugsweise ist dafür vorgesehen, dass die Spule Spulenwicklungen aufweist, welche parallel zu der Wandung der Gehäuseoberseite angeordnet sind oder in die Wandung der Gehäuseoberseite integriert sind. Bei dieser Variante ist es zweckmäßig, dass das Sensorelement des Bedienteils metallisch ausgebildet ist.

Alternativ ist zumindest der eine Sensor des Leistungsteils als ein kapazitiver Sensor ausgebildet. Dieser kapazitive Sensor weist vorzugsweise zumindest eine Messelektrode und eine Schirmelektrode auf. Zweckmäßig sind die Messelektrode und/oder die Schirmelektrode planar parallel zur Wandung der Gehäuseoberseite angeordnet. In besonderer Art kann vorgesehen sein, dass die Messelektrode und die Schirmelektrode im Inneren des Gehäuses des Leistungsteils, vorzugsweise im Aufnahmeraum oder in der Wandung der Gehäuseoberseite, integriert ausgebildet sind. Bei dieser Ausführung hat sich ein als Dielektrikum ausgebildetes Sensorelement des Bedienteils als besonders vorteilhaft erwiesen. Der kapazitive Sensor ist insbesondere derart ausgebildet, dass die Schaltelektronik mittels des zumindest einen Sensors sowohl eine horizontale Verschiebung des Sensorelements als auch eine vertikale Verschiebung des Sensorelements relativ zu der Gehäuseoberseite detektieren kann.

Eine weitere Variante des Elektroinstallationsgerätes sieht es vor, dass zumindest der eine Sensor des Leistungsteils vorteilhaft als zumindest ein elektromechanischer und/oder piezoelektrischen Dehnungsmessstreifen ausgebildet ist. Der jeweilige Dehnungsmessstreifen ist vorteilhaft zumindest an der Wandung der Gehäuseoberseite angeordnet. Zweckmäßig kann vorgesehen sein, dass der jeweilige Dehnungsmesstreifen im Inneren des Gehäuses des Leistungsteils, insbesondere in dem Aufnahmeraum, rückseitig an der Wandung der Gehäuseoberseite angeordnet ist. Alternativ kann vorgesehen sein, dass der jeweilige Dehnungsmessstreifen zumindest teilweise in der Wandung der Gehäuseoberseite integriert ausgebildet ist. Korrespondierend zu dem Dehnungsmessstreifen ist das Sensorelement des Bedienteils bei dieser Variante vorzugsweise als ein Kontaktelement zur Anlage an der Gehäuseoberseite oder zur Anlage an dem auf der Gehäuseoberseite angeordneten Dehnungsmessstreifen ausgebildet. Insbesondere misst der Dehnungsmessstreifen eine Dehnung der Wandung der Gehäuseoberseite, welche durch ein Andrücken des Kontaktelements an die Wandung der Gehäuseoberseite initiiert wird. Besonders vorteilhaft ist diese Ausführung kombinierbar mit einem vertikal zur Gehäuseoberseite beweglichen Sensorelement.

Gemäß einer weiteren Alternative weist die Wandung der Gehäuseoberseite des Leistungsteils mindestens eine Vertiefung auf. Zumindest der eine Sensor des Leistungsteils ist dabei vorteilhaft benachbart zu einer nach innen ragenden Wandung der Vertiefung im Inneren des Gehäuses des Leistungsteils, vorzugsweise im Aufnahmeraum, angeordnet. Auch kann vorgesehen sein, dass zumindest der eine Sensor des Leistungsteils zumindest teilweise in die nach innen ragende Wandung der Vertiefung integriert ist. Zweckmäßig bildet die Vertiefung eine gekapselte innere Öffnung. Bei dieser Variante kann es insbesondere vorgesehen sein, dass das Sensorelement des Bedienteils durch das Betätigungsmittel in die gekapselte innere Öffnung verschiebbar ausgebildet ist. Insbesondere ist diese Variante besonders geeignet für ein vertikal zur Gehäuseoberfläche bewegliches Sensorelement. Ein weiterer Vorteil besteht darin, dass bei dieser Variante zumindest der eine Sensor des Leistungsteils vorrangig das Sensorelement innerhalb der Vertiefung detektiert, wobei durch die gekapselte Ausbildung insbesondere eine Gefahr vor Fremdeinflüsse, die zu fehlerhaften Messungen führen könnten, verringert wird.

In einer weiterentwickelten Ausführungsvariante ist zumindest der eine Sensor des Leistungsteils als eine elektromagnetische Spule mit Spulenwicklungen ausgebildet. Die Spulenwicklungen sind dabei zweckmäßig um die nach innen ragende Wandung der Vertiefung im Inneren des Gehäuses des Leistungsteils, bevorzugt im Aufnahmeraum, ausgebildet. Vorzugsweise sind die Spulenwicklungen zumindest teilweise in die nach innen ragende Wandung der Vertiefung integriert. Bei dieser Variante bildet die Vertiefung eine gekapselte innere Spulenöffnung der elektromagnetischen Spule. Das zweckmäßig als ein Spulenkern ausgebildete Sensorelement des Bedienteils ist bei dieser Variante vorteilhaft durch das Betätigungsmittel in die gekapselte innere Spulenöffnung verschiebbar ausgebildet.

Wahlweise kann auch vorgesehen sein, dass zumindest der eine Sensor des Leistungsteils als ein kapazitiver Sensor ausgebildet ist, wobei die nach innen ragende Wandung der Vertiefung im Inneren des Gehäuses des Leistungsteils zwischen zumindest zwei Elektroden des kapazitiven Sensors ausgebildet ist. Die Elektroden können dabei auch alternativ zumindest teilweise in der nach innen ragenden Wandung der Vertiefung integriert ausgebildet sein. Es hat sich bei dieser Ausführungsform als besonders bevorzugt erwiesen, wenn das Sensorelement des Bedienteils als ein Dielektrikum ausgebildet ist. Analog zu den vorausgegangenen Ausführungsformen des Elektroinstallationsgerätes mit der nach innen ragenden Vertiefung ist vorzugsweise das Sensorelement durch das Betätigungsmittel in die gekapselte innere Öffnung verschiebbar ausgebildet.

Es liegt im Rahmen der Erfindung, dass, auch wenn es in den jeweiligen Beispielen nicht ausdrücklich beschrieben wird, das Elektroinstallationsgerät mehr als einen Sensor im Leistungsteil aufweisen kann. Ebenso kann das Betätigungsmittel mehr als ein Sensorelement aufweisen. Ebenso kann das Bedienteil mehr als ein Betätigungsmittel aufweisen.

Gemäß einer anderen, besonders gegen Schmutz, Feuchtigkeit und Fremdeinwirkung resistenten, Ausführungsform ist auf der zum Bedienteil weisenden Gehäuseoberseite des Leistungsteils mittels zumindest eines kapazitiven Sensors zumindest ein kapazitives Sensorfeld bereitgestellt. Dabei ist vorgesehen, dass das Bedienteil vorteilhaft eine von dem Leistungsteil abweisende Benutzerfläche als Betätigungsmittel zur Auswahl der Schaltzustände aufweist. Die Schaltzustände lassen sich dabei besonders zuverlässig auswählen, indem die Schaltelektronik derart ausgebildet ist, dass die Schaltelektronik fortlaufend die Kapazitäten des zumindest einen Sensorfeldes messen und mittels einer Auswertung der ersten und zweiten Ableitung der zeitlichen Veränderung der gemessenen Kapazitätswerte die Schaltzustände bestimmen kann. Vorteilhaft ist bei dieser Ausführungsform kein bewegliches Betätigungsmittel notwendig, so dass insbesondere der Benutzer mit einem Körperteil, insbesondere einem Finger, derart das Sensorfeld des kapazitiven Sensors beeinflussen kann, dass mittels der Schaltelektronik die jeweiligen Schaltzustände herbeigeführt werden können.

Dadurch, dass bei dieser Variante kein Betätigungsmittel und/oder zumindest das eine Sensorelement relativ zu der Gehäuseoberseite bewegt werden muss, um den Schaltzustand auszuwählen, entfällt eine bewegliche Lagerung des Betätigungsmittels, was insbesondere die maximale Betriebszeit erhöht bzw. den Verschleiß und die Gefahr von möglichen Defekten aufgrund einer geringen Anzahl von beweglichen Teilen verringert. Auch lassen sich Spaltmaße zuverlässig beständig einstellen und das optische Erscheinungsbild ideal an einen Montageort anpassen.

Gemäß einer weiterentwickelten Ausführungsform der vorgenannten Variante der Erfindung weist das Bedienteil zumindest eine planare Zusatzelektrode auf. Die Zusatzelektrode steigert die Zuverlässigkeit der Auswahl eines Schaltzustandes, indem die Zusatzelektrode mit dem kapazitiven Sensorfeld des Leistungsteils derart wechselwirkend ausgebildet ist, dass eine sensitive Fläche auf der von dem Leistungsteil abweisenden Benutzerfläche des Bedienteils generiert ist. Vorteilhafterweise kann die sensitive Fläche dabei größer ausgebildet sein als das kapazitive Sensorfeld auf der Gehäuseoberseite des Leistungsteils. Insbesondere kann durch eine Einwirkung auf die sensitive Fläche oder eine bloße Annäherung an die sensitive Fläche das Sensorfeld des Leistungsteils zur Auswahl der Schaltzustände beeinflusst werden. Dadurch, dass die jeweilige Zusatzelektrode eine sensitive Fläche generiert, welche größer sein kann als das Sensorfeld, kann der kapazitive Sensor kleiner dimensioniert werden. Auch kann dadurch die sensitive Fläche die gesamte Benutzerfläche des Bedienteils umfassen.

Eine vorteilhafte Ausführungsform der Erfindung besteht darin, dass auf der Gehäuseoberseite des Leistungsteils mittels mehr als einen Sensors, insbesondere zwei oder vier, kapazitiven Sensoren jeweils ein kapazitives Sensorfeld ausgebildet ist. Insbesondere können den kapazitiven Sensoren unterschiedliche Schaltfunktionen zugewiesen werden. Exemplarisch können die kapazitiven Sensoren unterschiedlichen elektrischen Verbrauchern zugewiesen werden. Beispielsweise kann jeder kapazitive Sensor derart ausgebildet sein, dass jeder kapazitive Sensor einen anderen elektrischen Verbraucher schalten kann, beispielsweise einschaltet oder ausschaltet, indem der Benutzer den jeweiligen Schaltzustand auswählt. Auch kann es zweckmäßig vorgesehen sein, dass die kapazitiven Sensoren unterschiedliche Schaltfunktionen für den gleichen elektrischen Verbraucher zur Verfügung stellen. Zweckmäßig kann vorgesehen sein, dass mittels zwei kapazitiver Sensoren eine Dimm-Funktion bereitgestellt wird und mit zwei weiteren kapazitiven Sensoren eine Ein-/Ausschalt-Funktion für den gleichen elektrischen Verbraucher gesteuert wird.

Vorzugsweise kann vorgesehen sein, dass die zumindest eine planare Zusatzelektrode des Bedienteils mit mehr als einem, insbesondere zwei oder vier, Sensorfeldern wechselwirkt. Zweckmäßig ist die Schaltelektronik im Leistungsteil derart ausgebildet, dass sie mittels der Veränderungen der jeweiligen Kapazitäten der jeweiligen kapazitiven Sensoren bei dem Auswählen des jeweiligen Schaltzustands eine Benutzereingabe, insbesondere eine Berührung der Benutzerfläche, örtlich auf der Benutzerfläche bestimmen kann. Der jeweilige Ort der Benutzereingabe durch den Benutzer auf der Benutzerfläche wird zweckmäßig mittels der Schaltelektronik zur Bestimmung des Schaltzustands ausgewertet.

Eine alternative oder ergänzende Ausführung sieht es vor, dass die Schaltelektronik anhand der Wechselwirkung von zwei oder mehr Sensorfeldern mit einer gemeinsamen Zusatzelektrode eine Ausrichtung bzw. Orientierung des Bedienteils relativ zu dem Leistungsteil bestimmen kann. Die Ausrichtung bzw. Orientierung des Bedienteils relativ zum Leistungsteil kann beispielsweise derart verarbeitet werden, dass der Benutzer abhängig von der Ausrichtung bzw. Orientierung unterschiedliche Schaltfunktionen und/oder Schaltzustände auswählen kann bzw. bereitgestellt bekommt.

Gemäß einer weiterentwickelten Variante weist das Bedienteil zumindest zwei planare Zusatzelektroden auf. Es hat sich als vorteilhaft erwiesen, dass jede Zusatzelektrode mit mehr als einem, insbesondere zwei, Sensorfeldern wechselwirkt.

In einer alternativen Variante ist vorgesehen, dass das Bedienteil in korrespondierender Anzahl zu der Anzahl der bereitgestellten Sensorfelder planare Zusatzelektroden aufweist. Besonders vorteilhaft schafft eine korrespondierende Anzahl von Zusatzelektroden und Sensorfeldern eine besonders zuverlässige Eingabesicherheit bei der Auswahl der jeweiligen Schaltzustände. Dafür sieht die vorteilhafte Ausführung vorzugsweise vor, dass jeweils eine Zusatzelektrode mit jeweils einem kapazitiven Sensorfeld derart wechselwirkend angeordnet und ausgebildet ist, dass jeweils eine sensitive Fläche je Zusatzelektrode auf der Benutzerfläche des Bedienteils ausgebildet ist. Zweckmäßig kann diese Variante dadurch verbessert werden, dass die sensitiven Flächen jeweils größer ausgebildet sind als das jeweilige kapazitive Sensorfeld auf der Gehäuseoberseite des Leistungsteils.

Beispielhaft ist auf der Gehäuseoberseite des Leistungsteils mittels vier im Wesentlichen quadratisch angeordneter kapazitiver Sensoren jeweils ein kapazitives Sensorfeld ausgebildet. Vorteilhaft weist dabei das Bedienteil zwei planare Zusatzelektroden auf. Das Bedienteil ist dabei mit seinen jeweiligen zwei Zusatzelektroden derart ausgebildet, dass jede Zusatzelektrode mit zwei horizontal nebeneinander angeordneten oder vertikal übereinander angeordneten benachbarten Sensorfeldern wechselwirkt.

Vorteilhaft ermöglicht diese Variante eine weiterentwickelte Ausführungsform, wonach das Bedienteil derart ausgebildet ist, dass es in einer ersten Einbaulage am Leistungsteil montierbar ist und in einer zweiten zu der ersten Einbaulage um 90° verdrehten Einbaulage am Leistungsteil montierbar ist. Hierbei ist es besonders bevorzugt, dass in der ersten Einbaulage jede Zusatzelektrode mit zwei horizontal nebeneinander angeordneten, benachbarten Sensorfeldern wechselwirkt und in der zweiten Einbaulage jede Zusatzelektrode mit zwei vertikal übereinander angeordneten, benachbarten Sensorfeldern wechselwirkt. Die Schaltelektronik kann dabei derart ausgebildet sein, dass die Schaltelektronik anhand der zwei mit jeweils einer Zusatzelektrode wechselwirkenden Sensorfeldern die Einbaulage des Bedienteils relativ zum Leistungsteil bestimmen und Schaltfunktionen abhängig von der Einbaulage bestimmen kann. Insbesondere können abhängig von der ersten und zweiten Einbaulage unterschiedliche elektrische Verbraucher angesteuert oder die Art der Ansteuerung des elektrischen Verbrauchers verändert werden, so dass exemplarisch in der ersten Einbaulage der Benutzer mit der Auswahl der Schaltzustände ein Licht oder eine Klimaanalage ein- oder ausschalten kann und in der zweiten Einbaulage der Benutzer mit der Auswahl der Schaltzustände das Licht dimmen oder eine Zieltemperatur der Klimaanlage einstellen kann.

Dadurch, dass das Bedienteil bzw. das als Benutzerfläche des Bedienteils ausgebildete Betätigungsmittel gemäß einer bevorzugten Ausführungsform mechanisch unbeweglich zu der Gehäuseoberseite des Leistungsteils gelagert ist, wird besonders effizient ein Eindringen von Fremdkörpern, wie Schmutz, oder ein Eindringen von Feuchtigkeit in einen Bereich zwischen Leistungsteil und Bedienteil verhindert. Insbesondere können sich derartige Fremdeinwirkungen im Bereich der kapazitiven Sensorfelder nachteilig auf die Auswertungen der kapazitiven Veränderungen bzw. auf die Auswahl der Schaltzustände auswirken.

Die zumindest eine planare Zusatzelektrode des Bedienteils kann zweckmäßig vor äußeren Einflüssen geschützt werden, indem die zumindest eine planare Zusatzelektrode auf einer zum Leistungsteil weisenden Montageseite einer Wandung der Benutzerfläche des Bedienteils angeordnet ist. Alternativ dazu kann ein effektiver Schutz bereitgestellt werden, indem die zumindest eine planare Zusatzelektrode des Bedienteils zumindest teilweise in eine Wandung der Benutzerfläche integriert ist.

Eine weitere Ausführungsform des Elektroinstallationsgerätes sieht es vor, dass die Schaltelektronik derart ausgebildet ist, dass die Schaltelektronik bei der Auswahl der Schaltzustände fortlaufend den zumindest einen elektronischen, elektromagnetischen, induktiven, kapazitiven, optischen, elektromechanischen oder piezoelektrischen Sensor überwacht und Messwerte bestimmt. Die Schaltelektronik ist darüber hinaus vorzugsweise derart eingerichtet und ausgebildet, dass die Schaltelektronik abhängig von der zeitlichen Veränderung der gemessenen Messwerte bestimmte Schaltfunktionen oder Schaltzustände einleiten kann und/oder fortlaufend die gemessenen Messwerte mit definierten Schwellwerten vergleicht und abhängig von einem Überschreiten oder Unterschreiten der gemessenen Messwerte relativ zu den definierten Schwellwerten bestimmte Schaltfunktionen oder Schaltzustände einleiten kann.

Im Gegensatz zu bestehenden Lösungen, die auf mechanische Schalter angewiesen sind, ermöglicht die vorliegende Erfindung eine vollständig berührungslose Bedienung über kapazitive Sensorfelder, was eine höhere Präzision und Benutzerfreundlichkeit eröffnet.

Insbesondere sieht es diese Variante vor, dass der Benutzer mittels bestimmter Schaltsequenzen und/oder mittels einer bestimmten Kraft und/oder einer bestimmten Geschwindigkeit und/oder einer bestimmten Geste und/oder eines bestimmten Stellwegs zumindest eine bestimmte Schaltfunktion einstellen und/oder einen bestimmten Schaltzustand auswählen kann.

Eine "bestimmte Schaltsequenz" kann in diesem Zusammenhang exemplarisch eine mehrfach aufeinanderfolgende Benutzereingabe in bestimmten zeitlichen Abständen auf das Betätigungsmittel des Bedienteils sein. Eine "bestimmte Kraft" kann in diesem Zusammenhang eine bestimmte Betätigungskraft sein, mit welcher der Benutzer auf das Betätigungsmittel drückt. Eine "bestimmte Geschwindigkeit" kann in diesem Zusammenhang eine bestimmte Betätigungsgeschwindigkeit sein, mit welcher der Benutzer auf das Betätigungsmittel drückt, insbesondere das Betätigungsmittel des Bedienteils verschiebt. Eine "bestimmte Geste" kann in diesem Zusammenhang beispielsweise eine bestimmte Art der Benutzereingabe sein, beispielsweise mit einer ganzen Handfläche, insbesondere an einer bestimmten Position auf dem Betätigungsmittel des Bedienteils, oder einem Finger, insbesondere an einer bestimmten Position auf dem Betätigungsmittel des Bedienteils, oder zwei oder mehr Finger, insbesondere an bestimmten Positionen auf dem Betätigungsmittel des Bedienteils. Ein "bestimmter Stellweg" kann in diesem Zusammenhang bei einem beweglich gelagerten Betätigungsmittel insbesondere der Betätigungsweg des Betätigungsmittels bzw. eines Teils des Betätigungsmittels sein, der bei einer Benutzereingabe relativ zu dem Funktionsteil bewegt wird. Schaltfunktionen können sich im Rahmen der erfinderischen Idee auf das Ansteuern unterschiedlicher elektrischer Verbraucher und/oder auf eine Art der Ansteuerung der elektrischen Verbraucher, beispielsweise Dimmen und/oder Schalten, beziehen.

Gemäß einer vorteilhaften Umsetzung ist das Elektroinstallationsgerät derart ausgebildet, dass die Schaltelektronik dazu ausgebildet ist, über die zum Auswählen des Schaltzustands eingesetzte Kraft einer Benutzereingabe und/oder über die Geschwindigkeit der Benutzereingabe des Benutzers differenzierte Schaltzustände oder Schaltfunktionen auszuwerten. Dabei kann exemplarisch ein leichter Druck auf das Betätigungsmittel, insbesondere eine Taste oder Wippe, (kleine Krafteinwirkung), einen voreingestellten Beleuchtungswert von z. B. 30 % bewirken und ein stärkerer Druck des Benutzers (große Krafteinwirkung) die Beleuchtung direkt auf 100 % einstellen. Des Weiteren ist ein vorteilhaftes Szenario vorsehbar, gemäß welchem eine mehrmalige Benutzereingabe mit kleiner Krafteinwirkung die Beleuchtung in vordefinierten Schritten verändert, eine kräftige Benutzereingabe aber wieder die Beleuchtung direkt auf 100 % schaltet. Zudem kann es vorgesehen sein, dass das Elektroinstallationsgerät derart ausgebildet ist, dass es möglich ist, durch Kombinationen von definierten Benutzereingaben, beispielsweise mit großer und kleiner Krafteinwirkung über eine definierte zeitliche Dauer, Konfigurationseinstellungen, beispielsweise die Beleuchtungsstärke der Lampe, zu speichern.

Auch ermöglicht es die besondere Variante der Erfindung, ein Betätigungsmittel, insbesondere eine Taste oder Wippe, mit zwei oder mehr unterschiedlichen Schaltfunktionen zu belegen. Als Beispiel wird einem als Taste ausgebildeten Betätigungsmittel die Schaltfunktion zugeordnet, eine Jalousie zu öffnen oder zu schließen sowie eine Beleuchtung einzuschalten oder auszuschalten. Vorteilhaft kann dabei vorgesehen sein, dass eine Benutzereingabe des Benutzers mit einer geringen Krafteinwirkung auf das Betätigungsmittel die Beleuchtung ein- bzw. ausschaltet und eine Benutzereingabe des Benutzers mit einer hohen Krafteinwirkung auf das Betätigungsmittel das Öffnen bzw. das Schließen der Jalousie bewirkt.

Zweckmäßig weist das Leistungsteil und/oder die Schaltelektronik einen Speicher zur Speicherung der Konfigurationseinstellungen auf. Alternativ oder ergänzend kann vorgesehen sein, dass in dem Speicher eine eingestellte bzw. ausgewählte Schaltfunktion als bestimmte Schaltfunktion gespeichert wird. Gemäß der als bestimmte Schaltfunktion gespeicherten Schaltfunktionen sind die auswählbaren Schaltzustände und die durch die jeweiligen Schaltzustände hervorgerufenen Wirkungen bestimmt.

Es ist zweckmäßig vorgesehen, dass die eingestellte bzw. ausgewählte Schaltfunktion als bestimmte Schaltfunktion im Speicher so lange gespeichert wird, bis eine andere Schaltfunktion eingestellt bzw. ausgewählt und als bestimmte Schaltfunktion gespeichert wird. Beispielsweise kann der Benutzer durch eine bestimmte Schaltsequenz von Benutzereingaben, exemplarisch drei aufeinanderfolgende Berührungen der Benutzerfläche in einem Zeitraum von einer Sekunde, als die bestimmte Schaltfunktion einstellen, die bewirkt, dass das Elektroinstallationsgerät einen ersten, als Deckenleuchte ausgebildeten, elektrischen Verbraucher steuert. Der Benutzer kann daraufhin einen ersten Schaltzustand auswählen, in welchem die Deckenleuchte angeschaltet ist und einen zweiten Schaltzustand auswählen, bei dem die Deckenleuchte ausgeschaltet ist. Die Zuweisung des Elektroinstallationsgerätes zur Deckenleuchte bzw. die Schaltfunktion bleibt dabei so lange gespeichert bzw. "aktiv", bis der Benutzer durch eine andere oder die gleiche bestimmte Schaltsequenz von Benutzereingaben eine andere Schaltfunktion als die bestimmte Schaltfunktion auswählt. So kann es beispielsweise vorgesehen sein, dass erneut drei aufeinanderfolgende Berührungen der Benutzerfläche in einem Zeitraum von einer Sekunde als die bestimmte Schaltfunktion eingestellt werden, die bewirkt, dass das Elektroinstallationsgerät nun einen anderen, beispielsweise als Stehlampe ausgebildeten, elektrischen Verbraucher steuert.

Auch kann es vorteilhaft vorgesehen sein, dass die eingestellte bzw. ausgewählte Schaltfunktion als bestimmte Schaltfunktion im Speicher temporär gespeichert wird, bis eine bestimmte Zeit abläuft oder insbesondere gemäß einer vorteilhaften Variante innerhalb dieser ablaufenden Zeit eine andere Schaltfunktion eingestellt bzw. ausgewählt und als bestimmte Schaltfunktion gespeichert wird. Beispielsweise kann der Benutzer durch eine bestimmte Schaltsequenz von Benutzereingaben, exemplarisch drei aufeinanderfolgende Berührungen der Benutzerfläche in einem Zeitraum von einer Sekunde, als die bestimmte Schaltfunktion einstellen, die bewirkt, dass das Elektroinstallationsgerät für einen bestimmten Zeitraum, beispielsweise 15 Sekunden, den ersten, als Deckenleuchte ausgebildeten, elektrischen Verbraucher steuert. Der Benutzer kann daraufhin einen ersten Schaltzustand auswählen, in welchem die Deckenleuchte angeschaltet ist und einen zweiten Schaltzustand auswählen, bei dem die Deckenleuchte ausgeschaltet ist. Die Zuweisung des Elektroinstallationsgerätes zur Deckenleuchte bzw. die Schaltfunktion bleibt dabei so lange gespeichert bzw. "aktiv", bis der bestimmte Zeitraum, in diesem Beispiel die 15 Sekunden, abgelaufen sind oder der Benutzer durch eine andere oder die gleiche bestimmte Schaltsequenz von Benutzereingaben eine andere Schaltfunktion als die bestimmte Schaltfunktion auswählt. So kann es beispielsweise vorgesehen sein, dass nach Ablauf des bestimmten Zeitraums von exemplarisch 15 Sekunden die Schaltelektronik in eine Basisschaltfunktion wechselt, gemäß welcher das Elektroinstallationsgerät den anderen, exemplarisch als Stehlampe ausgebildeten, elektrischen Verbraucher steuert.

Eine weitere Variante sieht es vor, dass die eingestellte bzw. ausgewählte Schaltfunktion gleichzeitig mit der Auswahl des Schaltzustands erfolgt. Beispielsweise kann der Benutzer mittels einer einfachen Berührung der Benutzerfläche zwischen einem ersten Schaltzustand auswählen, in welchem die Deckenleuchte angeschaltet ist und einem zweiten Schaltzustand, bei dem die Deckenleuchte ausgeschaltet ist. Zusätzlich kann der Benutzer durch eine bestimmte Schaltsequenz von Benutzereingaben, exemplarisch zwei aufeinanderfolgende Berührungen der Benutzerfläche in einem Zeitraum von einer Sekunde, wobei der Benutzer die zweite Berührung aufrechterhält, eine Leuchtstärke der Deckenleuchte entsprechend einer Dimmfunktion so lange verstärken, wie er die Benutzerfläche berührt. Ergänzend kann darüber hinaus vorgesehen sein, dass der Benutzer durch eine weitere bestimmte Schaltsequenz von Benutzereingaben, exemplarisch drei aufeinanderfolgende Berührungen der Benutzerfläche in einem Zeitraum von einer Sekunde, wobei der Benutzer die dritte Berührung aufrechterhält, eine Leuchtstärke der Deckenleuchte entsprechend einer Dimmfunktion so lange schwächen, wie die Benutzerfläche berührt wird.

Es versteht sich von selbst, dass alle in den vorgenannten Beispielen genannten elektrischen Verbraucher, wie insbesondere "Beleuchtung", "Deckenleuchte", "Jalousie", "Stehlampe", "Klimaanlage" und dergleichen, lediglich beispielhaft zur Veranschaulichung der jeweiligen Ausführungsvarianten angeführt wurden und die Ausführungsbeispiele selbstverständlich nicht auf die jeweiligen elektrischen Verbraucher beschränkt sind.

Es versteht sich von selbst, dass alle in den vorgenannten Beispielen genannten Betätigungsmittel, wie "Schalter", "Taster", "Dimmer", "Benutzerfläche" und dergleichen, lediglich beispielhaft zur Veranschaulichung der jeweiligen Ausführungsvarianten angeführt wurden und die Ausführungsbeispiele selbstverständlich nicht auf eine bestimmte Art von Betätigungsmittel beschränkt sind. Vielmehr kann jedes Betätigungsmittel entsprechend seiner Art der Bedienung in logischer Weise in den vorgenannten Ausführungsbeispielen angewandt werden. Insbesondere ist ein als Benutzerfläche ausgebildetes Betätigungsmittel, welches auf eine Berührung als Benutzereingabe reagiert, in logischer Konsequenz mit einem als Schalter oder Taster ausgebildeten Betätigungsmittel, welches auf eine mechanische Verschiebung als Benutzereingabe reagiert, austauschbar. Selbiges gilt für die Benutzereingaben "Berühren", "Drücken", "Verstellen" und dergleichen in logischer Art und Weise ebenfalls.

Weitere vorteilhafte Ausgestaltungen der Erfindung ergeben sich aus der folgenden Figurenbeschreibung und den abhängigen Unteransprüchen.

Es zeigen:
- Fig. 1: eine schematische Darstellung einer ersten Ausführungsform eines Elektroinstallationsgerätes mit einem vertikalbeweglichen Sensorelement,
- Fig. 2: eine schematische Darstellung einer weiteren Ausführungsform eines Elektroinstallationsgerätes mit einem horizontalbeweglichen Sensorelement,
- Fig. 3: eine Funktions-Prinzipskizze einer Ausführungsform eines kapazitiven Sensors mit einem horizontalbeweglichen Sensorelement eines Elektroinstallationsgerätes, insbesondere eines Elektroinstallationsgerätes gemäß Fig. 2,
- Fig. 4: eine Funktions-Prinzipskizze einer Ausführungsform eines Sensors mit einem horizontal- oder vertikalbeweglichen Sensorelement eines Elektroinstallationsgerätes, insbesondere eines Elektroinstallationsgerätes gemäß Fig. 1 oder 2,
- Fig. 5: eine Funktions-Prinzipskizze einer Ausführungsform eines induktiven Sensors mit einem horizontalbeweglichen Sensorelement eines Elektroinstallationsgerätes, insbesondere eines Elektroinstallationsgerätes gemäß Fig. 2,
- Fig. 6: eine Funktions-Prinzipskizze einer Ausführungsform eines kapazitiven Sensors mit einem vertikalbeweglichen Sensorelement eines Elektroinstallationsgerätes, insbesondere eines Elektroinstallationsgerätes gemäß Fig. 1,
- Fig. 7: eine Funktions-Prinzipskizze einer Ausführungsform eines induktiven Sensors mit einem vertikalbeweglichen Sensorelement eines Elektroinstallationsgerätes, insbesondere eines Elektroinstallationsgerätes gemäß Fig. 1,
- Fig. 8: eine schematische Darstellung einer weiteren Ausführungsform eines Elektroinstallationsgerätes mit vier kapazitiven Sensorfeldern und einem Bedienteil mit einer Zusatzelektrode,
- Fig. 9: eine schematische Darstellung einer weiteren Ausführungsform eines Elektroinstallationsgerätes mit vier kapazitiven Sensorfeldern und einem Bedienteil mit vier Zusatzelektroden,
- Fig. 10a/10b: schematische Darstellungen einer weiteren Ausführungsform eines Elektroinstallationsgerätes mit vier kapazitiven Sensorfeldern und einem Bedienteil mit zwei Zusatzelektroden und
- Fig. 11: eine schematische Schnittansicht entlang der Trenngerade A-A gemäß Fig. 10a.

In den verschiedenen Figuren der Zeichnung sind gleiche Teile stets mit denselben Bezugszeichen versehen.

Zu der anschließenden Beschreibung wird beansprucht, dass die Erfindung nicht auf die Ausführungsbeispiele und dabei nicht auf alle oder mehrere Merkmale von beschriebenen Merkmalskombinationen beschränkt ist, vielmehr ist jedes einzelne Teilmerkmal des/jedes Ausführungsbeispiels auch losgelöst von allen anderen im Zusammenhang damit beschriebenen Teilmerkmalen für sich und auch in Kombination mit beliebigen Merkmalen eines anderen Ausführungsbeispiels von Bedeutung für den Gegenstand der Erfindung.

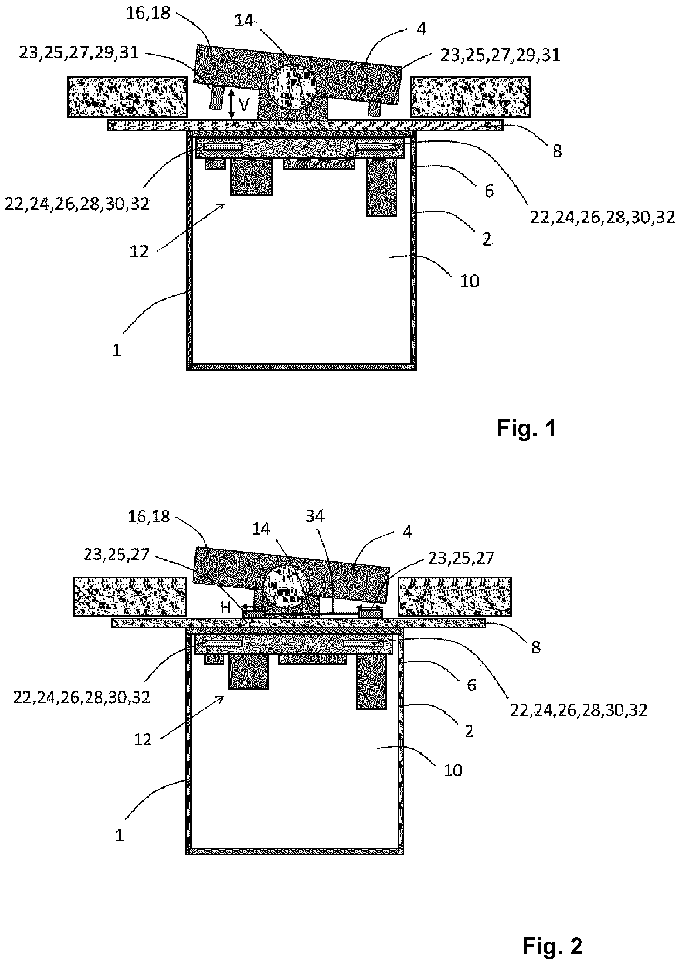

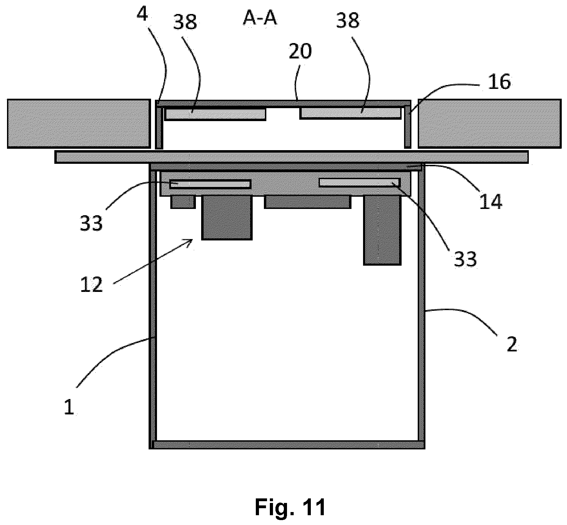

In den Fig. 1, 2 und 8 bis 11 sind verschiedene Ausführungsformen eines Elektroinstallationsgerätes 1 zur Steuerung eines elektrischen Verbrauchers dargestellt.

Das Elektroinstallationsgerät 1 weist ein Leistungsteil 2 und ein Bedienteil 4 auf. Es ist vorgesehen, dass das Leistungsteil 2 ein Gehäuse 6 mit Befestigungsmitteln zur Montage in einer Einbauöffnung aufweist. Die jeweiligen Befestigungsmittel sind in den Fig. 1, 2 und 8 bis 11 nicht dargestellt. Befestigungsmittel im Sinne der Erfindung können vorteilhaft mechanisch und/oder magnetisch ausgebildet sein. Insbesondere können die Befestigungsmittel als eine Verschraubung oder eine Krallenanordnung zur Verkeilung des Leistungsteils 2 mit der Einbauöffnung ausgebildet sein. Vorzugsweise weist das Leistungsteil 2 einen Tragring 8 zur Montage in der Einbauöffnung auf. Zweckmäßig kann die Einbauöffnung durch eine Unterputzdose oder eine Aufputzdose bereitgestellt werden.

Das Gehäuse 6 des Leistungsteils 2 weist darüber hinaus einen Aufnahmeraum 10 auf, in welchem eine Schaltelektronik 12 zur Überwachung und Auswertung von Schaltzuständen des Bedienteils 4 und zur Steuerung des Verbrauchers angeordnet ist. Die Schaltelektronik 12 und das Gehäuse 6 mit dem Aufnahmeraum 10 sind insbesondere in den Fig. 1 und 2 dargestellt.

Das Bedienteil 4 ist zur lösbaren Befestigung auf einer Wandung einer Gehäuseoberseite 14 des Leistungsteils 2 ausgebildet. Eine exemplarische Anordnung des Bedienteils 4 auf der Gehäuseoberseite 14 des Leistungsteils 2 ist insbesondere in den Fig. 1 und 2 dargestellt. Zweckmäßig kann das Bedienteil 4 und/oder das Leistungsteil 2 eine Montagekodierung aufweisen, welche die Montagerichtung oder die relative Einbaulage des jeweiligen Bedienteils 4 zu dem jeweiligen Leistungsteil 2 anzeigt. Dadurch wird die Montage erleichtert und Fehlern vorgebeugt.

Vorteilhaft ist vorgesehen, dass das Bedienteil 4 und das Leistungsteil 2 miteinander korrespondierende, insbesondere magnetische, Haltemittel und Gegenhaltemittel aufweisen. Vorzugsweise sieht es eine besondere Ausführung vor, dass die lösbare Befestigung des Bedienteils 4 an dem Leistungsteil 2 ausschließlich bei lagerichtigem Aufsetzen zustande kommt. Dies kann beispielsweise mittels der Auswahl der Polung bei magnetischen Haltemitteln und Gegenhaltemitteln erreicht werden. Vorteilhaft kommt es dadurch ausschließlich bei der lagerichtigen Positionierung zwischen dem jeweiligen Haltemittel und dem Gegenhaltemittel zur gewünschten Anziehung, wohingegen sich das Haltemittel und das Gegenhaltemittel bei einem verdrehten Montageversuch gegenseitig abstoßen. Vorteilhaft ist dadurch ein symmetrischer Aufbau der Teile bei Wahrung einer hohen Montagesicherheit bereitstellbar.

Insbesondere kann vorgesehen sein, dass das Bedienteil 4 und/oder das Leistungsteil 2 eine äußere Form mit einer Montagekontur aufweisen, so dass die jeweiligen Teile lediglich in einer für sie vorgesehenen Einbaulage montierbar sind und abweichende Einbaulagen, insbesondere durch eine formschlüssige Blockade, verhindert werden.

Alternativ oder ergänzend kann vorgesehen sein, dass das Bedienteil 4 und das Leistungsteil 2 miteinander korrespondierende Rast und/oder Klemmmittel aufweisen. Vorteilhaft sind die Rast und/oder Klemmmittel besonders geeignet, um eine sehr beständige Befestigung zur Verfügung zu stellen, so dass insbesondere eine Demontage entgegen einer von dem Bedienteil 4 zum Leistungsteil 2 weisenden Montagerichtung kraft- und/oder formschlüssig blockiert wird.

Alternativ oder ergänzend kann vorgesehen sein, dass das Bedienteil 4 mit dem Leistungsteil 2 zur lösbaren Befestigung verschraubbar ausgebildet ist. In diesem Zusammenhang kann vorgesehen sein, dass das Bedienteil 4 Durchbrüche zur Durchführung jeweils einer Montageschraube und das Gehäuse 6 des Leistungsteils 2 korrespondierende Gewindebohrungen zum Einschrauben der Montageschraube oder definierte Einschraubabschnitte zum Einschneiden von als selbstschneidende Schrauben ausgebildeten Montageschrauben aufweist.

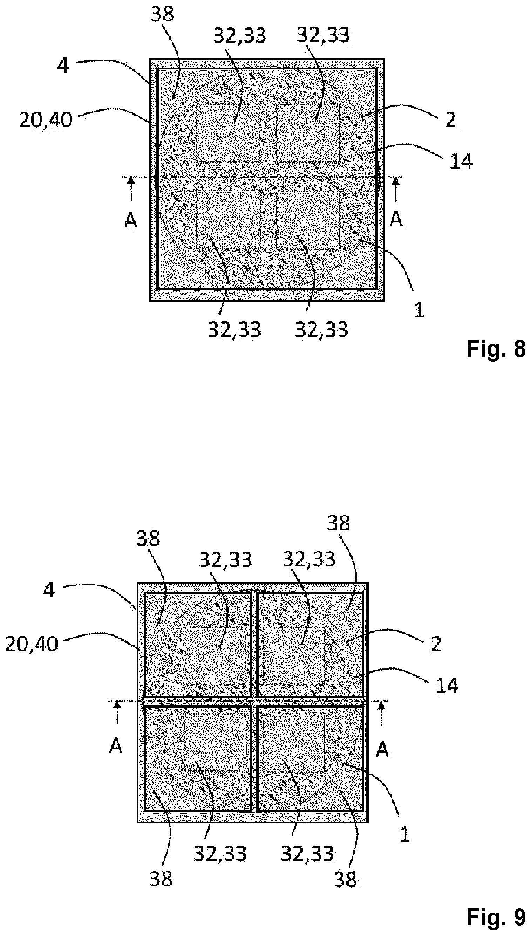

Es ist vorgesehen, dass das Bedienteil 4 des Elektroinstallationsgerät mindestens ein Betätigungsmittel 16 zur Auswahl der Schaltzustände aufweist. In den Fig. 1 und 2 ist zumindest ein vorteilhaft als Wippe 18 ausgebildetes Betätigungsmittel 16 dargestellt. In den Fig. 8 bis 11 ist das Betätigungsmittel 16 des Bedienteils 4 vorteilhaft als eine von dem Leistungsteil 2 abweisende Benutzerfläche 20 zur Auswahl der Schaltzustände ausgebildet. Der Benutzer kann zumindest zur Auswahl der jeweiligen Schaltzustände auf das Betätigungsmittel 16 einwirken. Im Rahmen der Erfindung wird das Einwirken des Benutzers auf das Betätigungsmittel 16 insbesondere als eine Benutzereingabe bezeichnet.

Erfindungsgemäß ist vorgesehen, dass das Leistungsteil 2 zumindest einen mit der Schaltelektronik 12 elektrisch verbundenen und mit dem Bedienteil 4 zusammenwirkenden elektronischen, elektromagnetischen, induktiven, kapazitiven, optischen, elektromechanischen oder piezoelektrischen Sensor 22, 24, 26, 28 aufweist. Die Verbindung zwischen dem Sensor 22, 24, 26, 28 und der Schaltelektronik 12 ist in den Fig. 1 und 2 dargestellt. Mittels des zumindest einen Sensors 22, 24, 26, 28 entfällt insbesondere die Notwendigkeit einer konstanten mechanischen Verbindung zwischen der Schaltelektronik 12 und dem Betätigungsmittel 16, siehe insbesondere die Ausführungsbeispiele in den Fig. 1 und 2.

Vorteilhaft ermöglicht es die Erfindung, dass zumindest die Gehäuseoberseite 14 des Leistungsteils 2 zum Aufnahmeraum 10 hin vollflächig geschlossen ausgebildet werden kann. Vorzugsweise ist dabei vorgesehen, dass keine Öffnung für eine elektrische Leitung oder eine mechanische Verbindung zwischen Bedienteil 4 und Leistungsteil 2 ausgebildet ist, wie es exemplarisch in den Fig. 1 und 2 dargestellt ist.

Vorteilhaft ist zumindest der eine Sensor 22, 24, 26, 28, 30, 32 gemäß einer besonderen Variante im Inneren des Gehäuses 6 angeordnet. Dafür ist es insbesondere vorgesehen, dass der jeweilige Sensor 22, 24, 26, 28, 30, 32 des Leistungsteils 2 im Aufnahmeraum 10 des Leistungsteils 2, zweckmäßig gemeinsam mit der Schaltelektronik 12, an einer Innenseite der Wandung der Gehäuseoberseite 14 angeordnet ist. In den Fig. 1 und 2 ist eine alternative Ausführung dargestellt, gemäß welcher zumindest der eine Sensor 22, 24, 26, 28, 30, 32 des Leistungsteils 2 zumindest teilweise in die Wandung der Gehäuseoberseite 14 integriert ist. Fig. 1 und 2 zeigen eine besondere Variante, gemäß welcher zumindest der eine Sensor 22, 24, 26, 28, 30, 32 bzw. die Sensoren 22, 24, 26, 28, 30, 32 vollständig in die Wandung der Gehäuseoberseite 14 integriert ist/sind.

Gemäß einer bevorzugten Ausführungsform des Elektroinstallationsgeräts ist vorgesehen, dass das Betätigungsmittel 16 des Bedienteils 4 zur Auswahl der Schaltzustände mechanisch zwischen zumindest zwei Stellungen gelagert ist. Vorteilhaft ist das Bedienteil 4 bzw. das Betätigungsmittel 16 als eine Taste oder eine Wippe 18, wie in den Fig. 1 und 2 dargestellt, ausgebildet. Bei dem mechanisch gelagerten Betätigungsmittel 16 ist zumindest der eine Sensor 22, 24, 26, 28, 30, 32 des Leistungsteils 2 zur Erfassung der mechanischen Stellung des Betätigungsmittels 16 des Bedienteils 4 ausgebildet.

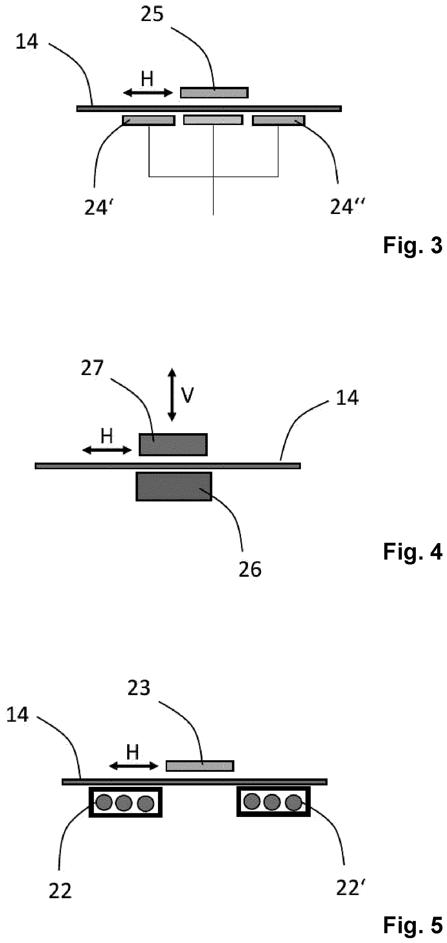

Wie in den Fig. 1 und 2 dargestellt, weist das Bedienteil 4 vorzugsweise ein relativ zu dem Sensor 22, 24, 26, 28, 30, 32 des Leistungsteils 2 in Abhängigkeit von der mechanischen Stellung des Betätigungsmittels 16 des Bedienteils 4 unterschiedlich positionierbares Sensorelement 23, 25, 27, 29, 31 auf. Zur Veranschaulichung unterschiedlicher Funktionsprinzipien sind in den Fig. 3 bis 7 im Wesentlichen die Sensorelemente 23, 25, 27, 29, 31 des Bedienteils 4 und zumindest der eine Sensor 22, 24, 26, 28, 30 des Leistungsteils 2 schematisch dargestellt. Das Sensorelement 23, 25, 27, 29, 31 ist vorzugsweise mit dem Betätigungsmittel 16 des Bedienteils 4 direkt oder indirekt mechanisch verbunden. Die Positionierung des Sensorelementes 23, 25, 27, 29, 31 bzw. die Betätigung des Sensorelements 23, 25, 27, 29, 31 ist dabei vorteilhaft von dem Sensor 22, 24, 26, 28, 30 des Leistungsteils 2 erfassbar.

Vorzugsweise ist das Sensorelement 23, 25, 27, 29, 31 optisch wirksam und/oder metallisch dielektrisch oder magnetisch ausgebildet. Es hat sich zudem alternativ oder ergänzend bewährt, das Sensorelement 23, 25, 27, 29, 31, wie in Fig. 1 dargestellt, einteilig mit dem Betätigungsmittel 16 auszubilden.

Gemäß einer bevorzugten Ausführung ist das Sensorelement 23, 25, 27 durch das Betätigungsmittel 16 außen entlang der Wandung der Gehäuseoberseite 14 des Leistungsteils 2 in horizontaler Richtung H verschiebbar ausgebildet. Diese Ausführung ist insbesondere in den Fig. 2 bis 5 dargestellt. Vorteilhaft kann vorgesehen sein, dass, wie in Fig. 2 angedeutet, eine Schwenkbewegung des Betätigungsmittels 16 um eine parallel zur Gehäuseoberseite 14 verlaufende Lagerachse 34 in eine lineare horizontal H zur Gehäuseoberseite 14 gerichtete Bewegung übersetzt wird.

Eine alternative Variante ist in Fig. 1 dargestellt. Vorteilhaft wird gemäß dieser Ausführung das Sensorelement 23, 25, 27, 29, 31 durch das Betätigungsmittel 16 außen in vertikaler Richtung V zu der Gehäuseoberseite 14 des Leistungsteils 2 verschoben. Insbesondere ist das Sensorelement 23, 25, 27, 29, 31 in dieser Ausführungsvariante relativ zu dem Betätigungsmittel 16 unbeweglich mit dem Betätigungsmittel 16 verbunden. Besonders bevorzugt hat sich dabei eine einteilige Ausbildung, insbesondere monolithisch einstückig, des Sensorelementes 23, 25, 27, 29, 31 mit dem Betätigungsmittel 16 erwiesen.

Gemäß einer vorteilhaften Ausführungsform ist zumindest der eine Sensor 22 des Leistungsteils 2 als eine planare elektromagnetische Spule 22 ausgebildet. Wie in Fig. 5 dargestellt, ist vorzugsweise vorgesehen, dass Spulenwicklungen 22' der Spule 22 parallel zu der Wandung der Gehäuseoberseite 14 angeordnet sind. Zum Schutz der Spulenwicklungen 22' ist es darüber hinaus vorteilhaft, wenn die Spulenwicklungen 22' bzw. die elektromagnetische Spule 22 entlang der Wandung der Gehäuseoberseite 14 im Inneren des Gehäuses 6 des Leistungsteils 2, vorzugsweise im Aufnahmeraum 10, angeordnet sind oder zumindest teilweise in die Wandung der Gehäuseoberseite 14 integriert sind. Damit das Sensorelement 23 vorteilhaft von dem als elektromagnetische Spule 22 ausgebildeten Sensor 22 detektiert werden kann, ist das Sensorelement 23 des Bedienteils 4 bei dieser Ausführungsvariante vorteilhaft metallisch ausgebildet. Diese Ausführungsvariante hat sich als besonders geeignet für eine Ausführungsvariante des Elektroinstallationsgerätes 1 mit einem horizontal zur Gehäuseoberseite 14 des Leistungsteils 2 verschiebbaren Sensorelement herausgestellt.

Ebenfalls besonders vorteilhaft für eine Variante des Elektroinstallationsgerätes 1 mit einem horizontal zur Gehäuseoberseite 14 des Leistungsteils 2 verschiebbaren Sensorelement 25 hat sich erwiesen, dass, wie in Fig. 3 dargestellt, zumindest der eine Sensor 24 des Leistungsteils 2 als ein kapazitiver Sensor 24 ausgebildet ist. Vorzugsweise weist der kapazitive Sensor 24 bei dieser Ausführung zumindest eine Messelektrode 24` und eine Schirmelektrode 24" auf, welche planar parallel zur Wandung der Gehäuseoberseite 14 angeordnet sind. Vorzugsweise wird der Schutz des zumindest einen Sensors 24 dadurch verbessert, dass die Messelektrode 24` und die Schirmelektrode 24" vorzugsweise im Inneren des Gehäuses 6 des Leistungsteils 2, vorzugsweise im Aufnahmeraum 10, oder zumindest teilweise in die Wandung der Gehäuseoberseite 14 integriert ausgebildet sind. Zur Detektion des Sensorelements 25 des Bedienteils 4 durch den kapazitiven Sensor 24 des Leistungsteils 2 ist das Sensorelement 25 des Bedienteils 4 vorzugsweise als ein Dielektrikum 25 ausgebildet ist.

In Fig. 4 ist eine weitere bevorzugte Variante des Elektroinstallationsgerätes 1 dargestellt. Gemäß dieser Variante ist zumindest der eine Sensor 26 des Leistungsteils 2 als ein elektromagnetischer Sensor 26 ausgebildet. Korrespondierend zu dem als elektromagnetisch ausgebildeten Sensor 26 des Leistungsteils 2 ist das Sensorelement 27 vorzugsweise magnetisch ausgebildet. Vorteilhaft ist der Sensor 26 besonders geeignet für sowohl horizontal zur Gehäuseoberfläche als auch vertikal zur Gehäuseoberfläche verschiebbare Sensorelemente 27. Zum Schutz des Sensors 26 ist vorzugsweise vorgesehen, dass dieser im Inneren des Gehäuses 6 des Leistungsteils 2, insbesondere im Aufnahmeraum 10, oder zumindest teilweise in die Wandung der Gehäuseoberseite 14 integriert ausgebildet ist.

Gemäß einer weiteren, nicht dargestellten, vorteilhaften Ausführungsform des Elektroinstallationsgerätes 1 ist zumindest der eine Sensor des Leistungsteils 2 als zumindest ein elektromechanischer und/oder piezoelektrischer Dehnungsmessstreifen ausgebildet. Der jeweilige Dehnungsmessstreifen ist insbesondere zumindest an der Wandung der Gehäuseoberseite 14, insbesondere im Inneren des Gehäuses 6 des Leistungsteils 2, rückseitig an der Wandung der Gehäuseoberseite 14 oder zumindest teilweise in die Wandung der Gehäuseoberseite 14 integriert ausgebildet. Das Sensorelement des Bedienteils 4 ist vorzugsweise bei dieser Ausführung als ein Kontaktelement zur Anlage an der Gehäuseoberseite 14 und/oder an dem jeweiligen Dehnungsmessstreifen ausgebildet.

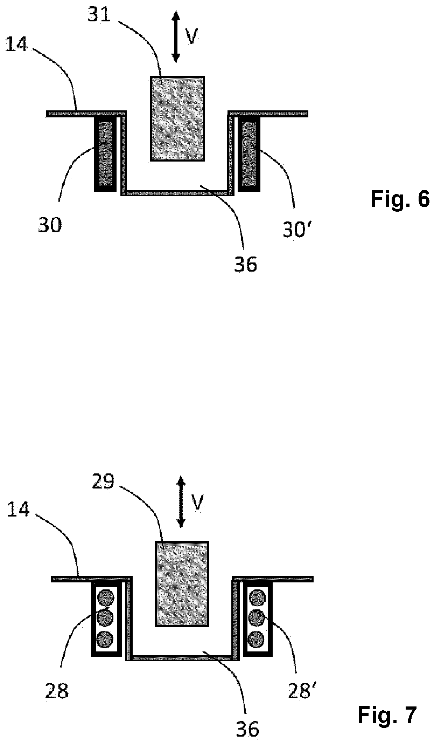

Gemäß den in den Fig. 6 und 7 dargestellten Ausführungsbeispielen kann vorgesehen sein, dass die Wandung der Gehäuseoberseite 14 des Leistungsteils 2 mindestens eine Vertiefung 36 aufweist. Vorzugsweise ist dabei zumindest der eine Sensor 28, 30 des Leistungsteils 2 benachbart zu einer nach innen ragenden Wandung der Vertiefung 36 im Inneren des Gehäuses 6 des Leistungsteils 2, vorzugsweise im Aufnahmeraum 10, wie in den Fig. 6 und 7 dargestellt, angeordnet. Alternativ ist zumindest der eine Sensor 28, 30 zumindest teilweise in die nach innen ragende Wandung der Vertiefung 36 integriert ausgebildet. Diese Ausführungsvariante sieht es vorteilhaft vor, dass die nach innen ragende Vertiefung 36 eine gekapselte innere Öffnung bildet. Zweckmäßig ist das Sensorelement 29, 31 des Bedienteils 4 durch das Betätigungsmittel 16 in die gekapselte innere Öffnung verschiebbar ausgebildet. Insbesondere ist das Sensorelement 29, 31 dabei, ähnlich wie in Fig. 1 dargestellt, mittels des Betätigungsmittels 16 vertikal zu der Gehäuseoberfläche des Leistungsteils 2 verschiebbar.

Eine besondere, in Fig. 6 dargestellte, Variante der vorgenannten Ausführungsform sieht es vor, dass zumindest der eine Sensor des Leistungsteils 2 als ein kapazitiver Sensor 30 ausgebildet ist. Die nach innen ragende Wandung der Vertiefung 36 im Inneren des Gehäuses 6 des Leistungsteils 2 ist zweckmäßig dabei zwischen zumindest zwei Elektroden 30' des kapazitiven Sensors 30 ausgebildet. Bei dieser Ausführung ist das, vorteilsweise als Dielektrikum 31 ausgebildete, Sensorelement 31 des Bedienteils 4 durch das Betätigungsmittel 16 in die gekapselte innere Öffnung verschiebbar.

Gemäß einer alternativen, in Fig. 7 dargestellten, Ausführung ist es vorgesehen, , dass zumindest der eine Sensor 28 des Leistungsteils 2 als eine elektromagnetische Spule 28 mit Spulenwicklungen 28` ausgebildet ist. Die Spulenwicklungen 28' sind dabei zweckmäßig um die nach innen ragende Wandung der Vertiefung 36 im Inneren des Gehäuses 6 des Leistungsteils 2, insbesondere in dem Aufnahmeraum 10, angeordnet. Diese Variante ist insbesondere in Fig. 7 dargestellt. Alternativ kann es vorteilhaft auch vorgesehen sein, dass die Spulenwicklungen 28' zumindest teilweise in die nach innen ragende Wandung der Vertiefung 36 integriert sind. Die Vertiefung 36 bildet bei dieser Ausführung vorzugsweise eine gekapselte innere Spulenöffnung der elektromagnetischen Spule 28, so dass das Sensorelement 29 des Bedienteils 4 als ein Spulenkern 29 ausgebildet mittels des Betätigungsmittels 16 in die gekapselte innere Spulenöffnung verschiebbar ist.

Es liegt im Rahmen der Erfindung, dass, auch wenn es in den jeweiligen Beispielen nicht ausdrücklich beschrieben wird, das Elektroinstallationsgerät mehr als einen Sensor 22, 24, 26, 28, 30, 32 im Leistungsteil 2 aufweisen kann, ebenso kann das Betätigungsmittel 16 mehr als ein Sensorelement 23, 25, 27, 29, 31 aufweisen, ebenso kann das Bedienteil 4 mehr als ein Betätigungsmittel 16 aufweisen.

Vorzugsweise ist auf der zum Bedienteil 4 weisenden Gehäuseoberseite 14 des Leistungsteils 2 mittels zumindest eines kapazitiven Sensors 32 zumindest ein kapazitives Sensorfeld 33 bereitgestellt. In den Fig. 8 bis 11 sind vorteilhafte Ausführungen dargestellt, gemäß welchen auf der Gehäuseoberseite 14 des Leistungsteils 2 mittels mehr als eines, insbesondere zwei oder vier, kapazitiver Sensoren 32 jeweils ein kapazitives Sensorfeld 33 ausgebildet ist. Vorzugsweise weist dabei das Bedienteil 4 eine von dem Leistungsteil 2 abweisende Benutzerfläche 20 als Betätigungsmittel 16 zur Auswahl der Schaltzustände auf. Es hat sich dabei als besonders vorteilhaft erwiesen, dass die Schaltelektronik 12 in einer bevorzugten Art derart ausgebildet ist, dass die Schaltelektronik 12 fortlaufend die Kapazitäten des zumindest einen Sensorfeldes 33 messen und mittels einer Auswertung der ersten und zweiten Ableitung der zeitlichen Veränderung der gemessenen Kapazitätswerte die Schaltzustände bestimmen kann. Die Schaltzustände lassen sich dabei besonders zuverlässig auswählen, indem zumindest der eine kapazitive Sensor 32 bzw. die Schaltelektronik 12 eine Änderung der Kapazität detektiert, welche der Benutzer, insbesondere bei einem Heranführen eines Köperteils, insbesondere eines Fingers, an das Sensorfeld 33 bzw. an das als Benutzerfläche 20 ausgebildete Betätigungsmittel 16 erzeugt.

Insbesondere ist vorgesehen, dass das Leistungsteil 2, wie in den Fig. 8 bis 11 dargestellt, vier im Wesentlichen quadratisch angeordnete kapazitive Sensoren 32 bzw. Sensorfelder 33 auf der Gehäuseoberseite 14 ausgebildet hat.

Gemäß einer vorteilhaften Weiterentwicklung ist vorgesehen, dass das Bedienteil 4 zumindest eine planare Zusatzelektrode 38 aufweist. Die zumindest eine Zusatzelektrode 38 ist mit dem kapazitiven Sensorfeld 33 des Leistungsteils 2 derart wechselwirkend ausgebildet, dass eine sensitive Fläche 40 auf der von dem Leistungsteil 2 abweisenden Benutzerfläche 20 des Bedienteils 4 generiert ist, welche größer ausgebildet ist als das kapazitive Sensorfeld 33 auf der Gehäuseoberseite 14 des Leistungsteils 2. Insbesondere in den Fig. 8 bis 11 sind Varianten des Elektroinstallationsgerätes 1 mit zumindest einer Zusatzelektrode 38 im bzw. am Bedienteil 4 dargestellt.

Eine besondere Ausführung sieht es vor, dass das Bedienteil 4 in korrespondierender Anzahl zu der Anzahl der bereitgestellten Sensorfelder 33 planare Zusatzelektroden 38 aufweist. Insbesondere sind, wie in Fig. 9 dargestellt, vier planare Zusatzelektroden 38 des Bedienteils 4 mit jeweils einem kapazitiven Sensorfeld 33 wechselwirkend ausgebildet. Vorteilhaft kann es vorgesehen sein, dass jeweils eine Zusatzelektrode 38 mit jeweils einem kapazitiven Sensorfeld 33 derart wechselwirkend angeordnet und ausgebildet ist, dass jeweils eine sensitive Fläche 40 je Zusatzelektrode 38 auf der Benutzerfläche 20 des Bedienteils 4 ausgebildet ist, welche jeweils größer ausgebildet ist als das jeweilige kapazitive Sensorfeld 33 auf der Gehäuseoberseite 14 des Leistungsteils 2.

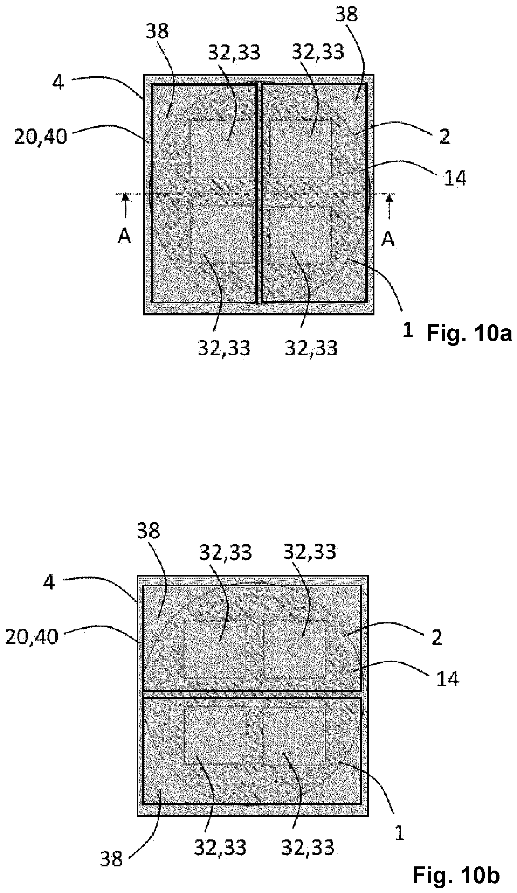

Vorteilhaft ist des Weiteren vorsehbar, dass die zumindest eine planare Zusatzelektrode 38 des Bedienteils 4 mit mehr als einem, insbesondere zwei oder vier, Sensorfeldern 33 wechselwirkt. In Fig. 8 ist dargestellt, dass eine planare Zusatzelektrode 38 des Bedienteils 4 mit vier kapazitiven Sensorfeldern 33 wechselwirkend ausgebildet ist. Insbesondere weist das Bedienteil 4, wie in Fig. 10a / 10b dargestellt, zumindest zwei planare Zusatzelektroden 38 auf, welche insbesondere jeweils mit mehr als einem, insbesondere zwei, Sensorfeldern 33 wechselwirkend ausgebildet sind.

Vorteilhaft kann es vorgesehen sein, dass die Schaltelektronik 12 anhand der Wechselwirkung von zwei oder mehr Sensorfeldern 33 mit einer gemeinsamen Zusatzelektrode 38 eine Ausrichtung bzw. Orientierung des Bedienteils 4 relativ zu dem Leistungsteil 2 bestimmen kann. Die Ausrichtung bzw. Orientierung des Bedienteils 4 relativ zum Leistungsteil 2 kann beispielsweise derart verarbeitet werden, dass der Benutzer abhängig von der Ausrichtung bzw. Orientierung unterschiedliche Schaltfunktionen und/oder Schaltzustände auswählen kann bzw. die Schaltelektronik derart ausgebildet ist, dass sie dem Benutzer unterschiedliche Schaltfunktionen und/oder Schaltzustände bereitstellt.

Bei einer ganz besonderen Ausführungsvariante des Elektroinstallationsgerätes 1 weist das Leistungsteil 2 vier im Wesentlichen quadratisch angeordnete kapazitive Sensoren auf, welche jeweils ein kapazitives Sensorfeld 33 auf der Gehäuseoberseite 14 des Leistungsteils 2 zur Verfügung stellen. Insbesondere weist dabei das Bedienteil 4 zwei planare Zusatzelektroden 38 auf, wie in Fig. 10a / 10b dargestellt. Das Leistungsteil 2 und das Bedienteils 4 sind gemäß dieser Variante derart vorteilhaft aufeinander abgestimmt ausgebildet, dass jede Zusatzelektrode 38 mit zwei horizontal nebeneinander angeordneten oder vertikal übereinander angeordneten benachbarten Sensorfeldern 33 wechselwirkt.

Vorteilhaft ermöglicht diese Ausführung eine weitere optionale Variante, wonach das Bedienteil 4 in zwei Einbaulagen an dem Leistungsteil 2 montierbar ausgebildet ist. Zweckmäßig ist das Bedienteil 4 demgemäß derart ausgebildet, dass es in einer ersten Einbaulage am Leistungsteil 2 montierbar ist und in einer zweiten, zu der ersten Einbaulage um 90° verdrehten, Einbaulage am Leistungsteil 2 montierbar ist, wobei in der ersten Einbaulage jede Zusatzelektrode 38 mit zwei horizontal nebeneinander angeordneten benachbarten Sensorfeldern 33 wechselwirkt und in der zweiten Einbaulage jede Zusatzelektrode 38 mit zwei vertikal übereinander angeordneten benachbarten Sensorfeldern 33 wechselwirkt. Hierbei kann es im Besonderen vorgesehen sein, dass, gemäß einer bevorzugten Ausführung des Elektroinstallationsgerätes 1, die Schaltelektronik 12 derart ausgebildet ist, dass sie anhand der zwei mit jeweils einer Zusatzelektrode 38 wechselwirkenden Sensorfelder 33 die Einbaulage des Bedienteils 4 relativ zum Leistungsteil 2 bestimmen und Schaltfunktionen abhängig von der Einbaulage bestimmen bzw. einstellen kann.

Zur Verbesserung der von der Schaltelektronik 12 mittels der kapazitiven Sensoren 32 gemessenen Werte, bzw. zur Verbesserung der zuverlässigen Bestimmung der Auswahl des Schaltzustandes durch den Benutzer, sieht es eine besondere Ausführungsvariante vor, dass jeweils zwischen zwei kapazitiven Sensoren 32 zwei Guardelektroden ausgebildet sind.

Das Bedienteil 4 bzw. das als Benutzerfläche 20 des Bedienteils 4 ausgebildete Betätigungsmittel 16 ist vorteilhaft mechanisch unbeweglich zu der Gehäuseoberseite 14 des Leistungsteils 2 gelagert. Diese Variante ist insbesondere in den Fig. 9 bis 11 dargestellt. Vorteilhaft weisen Elektroinstallationsgeräte 1 mit einem mechanisch unbeweglichen Betätigungsmittel 16 einen geringeren Verschleiß und eine längere Haltbarkeit auf als vergleichbare Elektroinstallationsgeräte 1 mit einem beweglichen Betätigungsmittel 16.

Vorzugsweise ist die zumindest eine planare Zusatzelektrode 38 des Bedienteils 4 auf einer zum Leistungsteil 2 weisenden Montageseite einer Wandung der Benutzerfläche 20 des Bedienteils 4 angeordnet. Alternativ sieht eine weitere Ausführung vor, dass die zumindest eine planare Zusatzelektrode 38 des Bedienteils 4 zumindest teilweise in eine Wandung der Benutzerfläche 20 integriert ist.

Vorzugsweise ist die Schaltelektronik 12 derart ausgebildet, dass die Schaltelektronik 12 bei der Auswahl der Schaltzustände fortlaufend den zumindest einen elektronischen, elektromagnetischen, induktiven, kapazitiven, optischen, elektromechanischen oder piezoelektrischen Sensor 22, 24, 26, 28, 30, 32 überwacht und Messwerte bestimmt. Besonders bevorzugt ist dabei die Schaltelektronik 12 derart ausgebildet und eingerichtet, dass sie abhängig von der zeitlichen Veränderung der gemessenen Messwerte bestimmte Schaltfunktionen oder Schaltzustände einleiten kann. Alternativ oder ergänzend ist die Schaltelektronik 12 derart ausgebildet und eingerichtet, dass sie fortlaufend die gemessenen Messwerte mit definierten Schwellwerten vergleicht und abhängig von einem Überschreiten oder Unterschreiten der gemessenen Messwerte relativ zu den definierten Schwellwerten bestimmte Schaltfunktionen oder Schaltzustände einleiten kann.

Die Erfindung ist nicht auf die dargestellten und beschriebenen Ausführungsbeispiele beschränkt, sondern umfasst auch alle im Sinne der Erfindung gleichwirkenden Ausführungen. Es wird ausdrücklich betont, dass die Ausführungsbeispiele nicht auf alle Merkmale in Kombination beschränkt sind, vielmehr kann jedes einzelne Teilmerkmal auch losgelöst von allen anderen Teilmerkmalen für sich eine erfinderische Bedeutung haben. Ferner ist die Erfindung bislang auch noch nicht auf die im Anspruch 1 definierte Merkmalskombination beschränkt, sondern kann auch durch jede beliebige andere Kombination von bestimmten Merkmalen aller insgesamt offenbarten Einzelmerkmale definiert sein. Dies bedeutet, dass grundsätzlich praktisch jedes Einzelmerkmal des Anspruchs 1 weggelassen beziehungsweise durch mindestens ein an anderer Stelle der Anmeldung offenbartes Einzelmerkmal ersetzt werden kann.

### Bezugszeichenliste

- 1: Elektroinstallationsgerät
- 2: Leistungsteil
- 4: Bedienteil
- 6: Gehäuse
- 8: Tragring
- 10: Aufnahmeraum
- 12: Schaltelektronik
- 14: Gehäuseoberseite
- 16: Betätigungsmittel
- 18: Wippe
- 20: Benutzerfläche
- 22, 24, 26, 28, 30, 32: Sensoren des Leistungsteils
- 23, 25, 27, 29, 30: Sensorelemente des Bedienteils
- 22': Spulenwicklungen
- 24': Messelektrode
- 24": Schirmelektrode
- 28': Spulenwicklungen
- 30': Elektroden
- 33: Sensorfeld
- 34: Lagerachse
- 36: Vertiefung
- 38: Zusatzelektrode
- 40: Sensitive Fläche

- H: Horizontale Bewegungsrichtung
- V: Vertikale Bewegungsrichtung

## Patentansprüche

1. Elektroinstallationsgerät (1) zur Steuerung eines elektrischen Verbrauchers, aufweisend ein Leistungsteil (2) und ein Bedienteil (4), wobei das Leistungsteil (2) ein Gehäuse (6) mit Befestigungsmitteln zur Montage in einer Einbauöffnung und in einem Aufnahmeraum (10) des Gehäuses (6) eine Schaltelektronik (12) zur Überwachung und Auswertung von Schaltzuständen des Bedienteils (4) und zur Steuerung des Verbrauchers aufweist, und das Bedienteil (4) zur lösbaren Befestigung auf einer Wandung einer Gehäuseoberseite (14) des Leistungsteils (2) ausgebildet ist, wobei das Bedienteil (4) mindestens ein Betätigungsmittel (16) zur Auswahl der Schaltzustände aufweist,
**dadurch gekennzeichnet, dass**
das Leistungsteil (2) zumindest einen mit der Schaltelektronik (12) elektrisch verbundenen und mit dem Bedienteil (4) zusammenwirkenden elektronischen, elektromagnetischen, induktiven, kapazitiven, optischen, elektromechanischen oder piezoelektrischen Sensor (22, 24, 26, 28, 30, 32) aufweist.

2. Elektroinstallationsgerät (1) nach Anspruch 1,
**dadurch gekennzeichnet, dass**
zumindest die Gehäuseoberseite (14) des Leistungsteils (2) zum Aufnahmeraum (10) hin vollflächig geschlossen, insbesondere ohne eine Öffnung für eine elektrische Leitung oder eine mechanische Verbindung zwischen Bedienteil (4) und Leistungsteil (2), ausgebildet ist.

3. Elektroinstallationsgerät (1) nach Anspruch 1 oder 2,
**dadurch gekennzeichnet, dass**
zumindest der eine Sensor (22, 24, 26, 28, 30, 32) im Inneren des Gehäuses (6), insbesondere im Aufnahmeraum (10), des Leistungsteils (2) an einer Innenseite der Wandung der Gehäuseoberseite (14) angeordnet ist.

4. Elektroinstallationsgerät (1) nach Anspruch 1 oder 2,
**dadurch gekennzeichnet, dass**
zumindest der eine Sensor (22, 24, 26, 28, 30, 32) des Leistungsteils (2) zumindest teilweise in die Wandung der Gehäuseoberseite (14) integriert ist.

5. Elektroinstallationsgerät (1) nach einem der Ansprüche 1 bis 4,
**dadurch gekennzeichnet, dass**
das Betätigungsmittel (16) des Bedienteils (4) zur Auswahl der Schaltzustände mechanisch zwischen zumindest zwei Stellungen gelagert ist, und zumindest der eine Sensor (22, 24, 26, 28, 30) des Leistungsteils (2) zur Erfassung der mechanischen Stellung des Betätigungsmittels (16) des Bedienteils (4) ausgebildet ist.

6. Elektroinstallationsgerät (1) nach Anspruch 5,
**dadurch gekennzeichnet, dass**
das Betätigungsmittel (16) als eine Wippe (18) oder ein Taster ausgebildet ist.

7. Elektroinstallationsgerät (1) nach Anspruch 5 oder 6,
**dadurch gekennzeichnet, dass**
das Bedienteil (4) ein relativ zu dem Sensor (22, 24, 26, 28, 30) des Leistungsteils (2) in Abhängigkeit von der mechanischen Stellung des Betätigungsmittels (16, 18) des Bedienteils (4) unterschiedlich positionierbares Sensorelement (23, 25, 27, 29, 31) aufweist, welches mit dem Betätigungsmittel (16) des Bedienteils (4) direkt oder indirekt mechanisch verbunden ist und dessen Betätigung von dem Sensor (22, 24, 26, 28, 30) des Leistungsteils (2) erfassbar ist.

8. Elektroinstallationsgerät (1) nach Anspruch 7,
**dadurch gekennzeichnet, dass**
das Sensorelement (23, 25, 27) durch das Betätigungsmittel (16) außen entlang der Wandung der Gehäuseoberseite (14) des Leistungsteils (2) in horizontaler Richtung (H) verschiebbar ausgebildet ist.

9. Elektroinstallationsgerät (1) nach Anspruch 7,
**dadurch gekennzeichnet, dass**
das Sensorelement (23, 25, 27, 29, 31) durch das Betätigungsmittel (16) außen in vertikaler Richtung (V) zu der Gehäuseoberseite (14) des Leistungsteils (2) verschiebbar ausgebildet ist.

10. Elektroinstallationsgerät (1) nach Anspruch 8 oder 9,
**dadurch gekennzeichnet, dass**
zumindest der eine Sensor (22) des Leistungsteils (2) als eine planare elektromagnetische Spule (22) ausgebildet ist, wobei Spulenwicklungen (22`) der Spule (22) parallel zu der Wandung der Gehäuseoberseite (14), insbesondere entlang der Wandung der Gehäuseoberseite (14) im Inneren des Gehäuses (6) des Leistungsteils (2), vorzugsweise im Aufnahmeraum (10), angeordnet sind oder zumindest teilweise in die Wandung der Gehäuseoberseite (14) integriert sind und das Sensorelement (23) des Bedienteils (4) metallisch ausgebildet ist.

11. Elektroinstallationsgerät (1) nach Anspruch 8 oder 9,
**dadurch gekennzeichnet, dass**
zumindest der eine Sensor (24) des Leistungsteils (2) als ein kapazitiver Sensor (24) ausgebildet ist und zumindest eine Messelektrode (24`) und eine Schirmelektrode (24") aufweist, welche planar parallel zur Wandung der Gehäuseoberseite (14) angeordnet sind, insbesondere im Inneren des Gehäuses (6) des Leistungsteils (2), vorzugsweise im Aufnahmeraum (10) oder zumindest teilweise in die Wandung der Gehäuseoberseite (14) integriert ausgebildet sind, wobei das Sensorelement (25) des Bedienteils (4) als ein Dielektrikum (25) ausgebildet ist.

12. Elektroinstallationsgerät (1) nach Anspruch 8,
**dadurch gekennzeichnet, dass**
zumindest der eine Sensor des Leistungsteils (2) als zumindest ein elektromechanischer und/oder piezoelektrischen Dehnungsmessstreifen ausgebildet ist, welcher zumindest an der Wandung der Gehäuseoberseite (14), insbesondere im Inneren des Gehäuses (6) des Leistungsteils (2), rückseitig an der Wandung der Gehäuseoberseite (14) oder zumindest teilweise in die Wandung der Gehäuseoberseite (14) integriert ausgebildet ist und das Sensorelement des Bedienteils (4) als ein Kontaktelement zur Anlage an der Gehäuseoberseite (14) oder an dem jeweiligen Dehnungsmessstreifen ausgebildet ist.

13. Elektroinstallationsgerät (1) nach Anspruch 8,
**dadurch gekennzeichnet, dass**
die Wandung der Gehäuseoberseite (14) des Leistungsteils (2) mindestens eine Vertiefung (36) aufweist und zumindest der eine Sensor (28, 30) des Leistungsteils (2) benachbart zu einer nach innen ragenden Wandung der Vertiefung (36) im Inneren des Gehäuses (6) des Leistungsteils (2), vorzugsweise im Aufnahmeraum (10), angeordnet ist oder zumindest teilweise in die nach innen ragende Wandung der Vertiefung (36) integriert ist, so dass die Vertiefung (36) eine gekapselte innere Öffnung bildet und das Sensorelement (29, 31) des Bedienteils (4) durch das Betätigungsmittel (16) in die gekapselte innere Öffnung verschiebbar ausgebildet ist.

14. Elektroinstallationsgerät (1) nach Anspruch 13,
**dadurch gekennzeichnet, dass**
zumindest der eine Sensor (28) des Leistungsteils (2) als eine elektromagnetische Spule (28) mit Spulenwicklungen (28`), welche um die nach innen ragende Wandung der Vertiefung (36) im Inneren des Gehäuses (6) des Leistungsteils (2), insbesondere in dem Aufnahmeraum (10), angeordnet sind oder zumindest teilweise in die nach innen ragende Wandung der Vertiefung (36) integriert sind, so dass die Vertiefung (36) eine gekapselte innere Spulenöffnung der elektromagnetischen Spule (28) bildet, und das Sensorelement (29) des Bedienteils (4) als ein Spulenkern (29) ausgebildet ist, welcher durch das Betätigungsmittel (16) in die gekapselte innere Spulenöffnung verschiebbar ist.

15. Elektroinstallationsgerät (1) nach Anspruch 13,
**dadurch gekennzeichnet, dass**
zumindest der eine Sensor (30) des Leistungsteils (2) als ein kapazitiver Sensor (30) ausgebildet ist, wobei die nach innen ragende Wandung der Vertiefung (36) im Inneren des Gehäuses (6) des Leistungsteils (2) zwischen zumindest zwei Elektroden (30`) des kapazitiven Sensors (30) ausgebildet ist, und das Sensorelement (31) des Bedienteils (4) als ein Dielektrikum (31) ausgebildet ist, welches durch das Betätigungsmittel (16) in die gekapselte innere Öffnung verschiebbar ist.

16. Elektroinstallationsgerät (1) nach einem der Ansprüche 1 bis 4,
**dadurch gekennzeichnet, dass**
auf der zum Bedienteil (4) weisenden Gehäuseoberseite (14) des Leistungsteils (2) mittels zumindest eines kapazitiven Sensors (32) zumindest ein kapazitives Sensorfeld (33) bereitgestellt ist, wobei das Bedienteil (4) eine von dem Leistungsteil (2) abweisende Benutzerfläche (20) als Betätigungsmittel (16) zur Auswahl der Schaltzustände aufweist, wobei die Schaltelektronik (12) derart ausgebildet ist, dass die Schaltelektronik (12) fortlaufend die Kapazitäten des zumindest einen Sensorfeldes (33) messen und mittels einer Auswertung der ersten und zweiten Ableitung der zeitlichen Veränderung der gemessenen Kapazitätswerte die Schaltzustände bestimmen kann.

17. Elektroinstallationsgerät (1) nach Anspruch 16,
**dadurch gekennzeichnet, dass**
das Bedienteil (4) zumindest eine planare Zusatzelektrode (38) aufweist, welche mit dem kapazitiven Sensorfeld (33) des Leistungsteils (2) derart wechselwirkend ausgebildet ist, dass eine sensitive Fläche (40) auf der von dem Leistungsteil (2) abweisenden Benutzerfläche (20) des Bedienteils (4) generiert ist, welche größer ausgebildet ist als das kapazitive Sensorfeld (33) auf der Gehäuseoberseite (14) des Leistungsteils (2).

18. Elektroinstallationsgerät (1) nach Anspruch 17,
**dadurch gekennzeichnet, dass**
dass das Bedienteil (4) in korrespondierender Anzahl zu der Anzahl der bereitgestellten Sensorfelder (33) planare Zusatzelektrode (38) aufweist, wobei jeweils eine Zusatzelektrode (38) mit jeweils einem kapazitiven Sensorfeld (33) derart wechselwirkend angeordnet und ausgebildet ist, dass jeweils eine sensitive Fläche (40) je Zusatzelektrode (38) auf der Benutzerfläche (20) des Bedienteils (4) ausgebildet ist, welche jeweils größer ausgebildet sind als das jeweilige kapazitive Sensorfeld (33) auf der Gehäuseoberseite (14) des Leistungsteils (2).

19. Elektroinstallationsgerät (1) nach Anspruch 17,
**dadurch gekennzeichnet, dass**
auf der Gehäuseoberseite (14) des Leistungsteils (2) mittels mehr als eines, insbesondere zwei oder vier, kapazitiven Sensoren (32) jeweils ein kapazitives Sensorfeld (33) ausgebildet ist, wobei die zumindest eine planare Zusatzelektrode (38) des Bedienteils (4) mit mehr als einem, insbesondere zwei oder vier Sensorfeldern (33) wechselwirkt.

20. Elektroinstallationsgerät (1) nach Anspruch 19,
**dadurch gekennzeichnet, dass**
das Bedienteil (4) zumindest zwei planare Zusatzelektroden (38) aufweist, welche insbesondere jeweils mit mehr als einem, insbesondere zwei, Sensorfeldern (33) wechselwirken.

21. Elektroinstallationsgerät (1) nach Anspruch 20,
**dadurch gekennzeichnet, dass**
auf der Gehäuseoberseite (14) des Leistungsteils (2) mittels vier im Wesentlichen quadratisch angeordneten kapazitiven Sensoren (32) jeweils ein kapazitives Sensorfeld (33) ausgebildet ist, wobei das Bedienteil (4) zwei planare Zusatzelektroden (38) aufweist, wobei jede Zusatzelektrode (38) mit zwei horizontal nebeneinander angeordneten oder vertikal übereinander angeordneten benachbarten Sensorfeldern (33) wechselwirkt.

22. Elektroinstallationsgerät (1) nach Anspruch 21,
**dadurch gekennzeichnet, dass**
das Bedienteil (4) derart ausgebildet ist, dass es in einer ersten Einbaulage am Leistungsteil (2) montierbar ist und in einer zweiten, zu der ersten Einbaulage um 90° verdrehten Einbaulage am Leistungsteil (2) montierbar ist, wobei in der ersten Einbaulage jede Zusatzelektrode (38) mit zwei horizontal nebeneinander angeordneten benachbarten Sensorfeldern (33) wechselwirkt und in der zweiten Einbaulage jede Zusatzelektrode (38) mit zwei vertikal übereinander angeordneten benachbarten Sensorfeldern (33) wechselwirkt.

23. Elektroinstallationsgerät (1) nach Anspruch 22,
**dadurch gekennzeichnet, dass**
die Schaltelektronik (12) derart ausgebildet ist, dass sie anhand der zwei mit jeweils einer Zusatzelektrode (38) wechselwirkenden Sensorfeldern (33) die Einbaulage des Bedienteils (4) relativ zum Leistungsteil (2) bestimmen und Schaltfunktionen abhängig von der Einbaulage bestimmen kann.

24. Elektroinstallationsgerät (1) nach einem der Ansprüche 18 bis 23,
**dadurch gekennzeichnet, dass**
jeweils zwischen zwei kapazitiven Sensoren (32) zwei Guardelektroden ausgebildet sind.

25. Elektroinstallationsgerät (1) nach einem der Ansprüche 16 bis 24,
**dadurch gekennzeichnet, dass**
das Bedienteil (4) und das als Benutzerfläche (20) des Bedienteils (4) ausgebildete Betätigungsmittel (16) mechanisch unbeweglich zu der Gehäuseoberseite (14) des Leistungsteils (2) gelagert sind.

26. Elektroinstallationsgerät (1) nach einem der Ansprüche 16 bis 25,
**dadurch gekennzeichnet, dass**
die zumindest eine planare Zusatzelektrode (38) des Bedienteils (4) auf einer zum Leistungsteil (2) weisenden Montageseite einer Wandung der Benutzerfläche (20) des Bedienteils (4) angeordnet ist.

27. Elektroinstallationsgerät (1) nach einem der Ansprüche 16 bis 25,
**dadurch gekennzeichnet, dass**
die zumindest eine planare Zusatzelektrode (38) des Bedienteils (4) zumindest teilweise in eine Wandung der Benutzerfläche (20) integriert ist.

28. Elektroinstallationsgerät (1) nach einem der Ansprüche 1 bis 27,
**dadurch gekennzeichnet, dass**
die Schaltelektronik (12) derart ausgebildet ist, dass die Schaltelektronik (12) bei der Auswahl der Schaltzustände fortlaufend den zumindest einen elektronischen, elektromagnetischen, induktiven, kapazitiven, optischen, elektromechanischen oder piezoelektrischen Sensor (22, 24, 26, 28, 30, 32) überwacht und Messwerte bestimmt und abhängig von der zeitlichen Veränderung der gemessenen Messwerte bestimmte Schaltfunktionen oder Schaltzustände einleiten kann und/oder fortlaufend die gemessenen Messwerte mit definierten Schwellwerten vergleicht und abhängig von einem Überschreiten oder Unterschreiten der gemessenen Messwerte relativ zu den definierten Schwellwerten bestimmte Schaltfunktionen oder Schaltzustände einleiten kann.
